# EUROPEAN PATENT SPECIFICATION

(11) **EP 3 476 040 B1**
(45) Date of publication and mention of the grant of the patent: **13.04.2022**
(21) Application number: 17820460.8
(22) Date of filing: 21.06.2017
(51) Int. Cl.: H02S 40/30, H01L 31/02, H01L 31/05, H02S 40/38, H01L 31/048, H01L 31/049

(54) **SOLAR CELL MODULE AND METHOD FOR MANUFACTURING THE SAME**
SOLARZELLENMODUL UND VERFAHREN ZUR HERSTELLUNG DAVON
MODULE DE CELLULE SOLAIRE ET SON PROCÉDÉ DE FABRICATION

(30) Priority: 28.06.2016 KR 20160081134; 28.06.2016 KR 20160081135; 07.07.2016 KR 20160086336
(43) Date of publication of application: 01.05.2019
(73) Proprietor: LG Electronics Inc., Seoul 07336 (KR)
(72) Inventor: HWANG, Eonjoo, Seoul 08592 (KR); KIM, Jungguen, Seoul 08592 (KR); SONG, Yong, Seoul 08592 (KR); WOO, Jeonghun, Seoul 08592 (KR); JEON, Joonho, Seoul 08592 (KR)
(74) Representative: Katérle, Axel
(86) International application number: PCT/KR2017/006512
(87) International publication number: WO 2018/004183

(56) References cited:
- EP-A1- 2 395 563
- JP-A- 2002 353 487
- JP-A- 2013 168 657
- JP-A- 2015 175 816
- JP-B2- 5 082 870
- JP-B2- 5 869 501
- KR-A- 20110 042 951
- KR-A- 20140 009 890
- KR-B1- 101 045 273
- US-A1- 2009 032 087
- US-A1- 2014 224 299

## Description

### [Technical Field]

The present disclosure relates to a solar cell module configured to produce electric power using light, and a manufacturing method thereof.

### [Background Art]

A solar cell is configured to convert light energy into an electric energy. In general, a solar cell includes a P type semiconductor and an N type semiconductor, and when the solar cell receives light, electric charges migrate to cause a potential difference.

A solar cell module refers to a module having a solar cell to produce electric power from light. A module refers to a constituent unit of a machine or a system and indicates an independent unit assembled to several electronic components or mechanical components to have a specific function. Thus, the solar cell module may be understood as indicating an independent unit having a solar cell and having a function of producing electric power from light.

A small solar cell module used as a driving power source of an electronic component generally has a structure including a printed circuit board (PCB), a solar cell, a protective layer formed on the entire surface of the solar cell, and an encapsulant layer formed between the solar cell and the protective layer. One or more solar cells are mounted on the PCB and electrically connected to an electrode connection part of the PCB. The solar cells are encapsulated by the protective layer and the encapsulant layer.

When a solar cell module is utilized in an electronic device, the electronic device may be driven using 1) indoor light supplied from a fluorescent light or an LED or 2) using natural light provided from the sun, without having to connect a separate power cable to the electronic device. Thus, compared with the related art electronic device which is necessarily to be connected to a separate power cable, the electronic device having a solar cell module is not limited in an installation place.

In spite of the advantages, however, the related art solar cell module has some problems to be solved.

First, component mounting is performed manually. The related art solar cell module has a component vulnerable to heat, and thus, a high temperature surface mount technology (SMT) cannot be applied during a process of manufacturing the solar cell module or during another process of using the solar cell module. Instead, in the related art solar cell module, components are mounted through a manual operation, and thus, it is difficult to secure process reliability and an operation pace is very slow.

Next, the related art solar cell module does not have sufficient light transmittance. Since the solar cell module produces electric power using light incident to a solar cell, high light transmittance is prerequisite for improvement of efficiency of the solar cell module. However, the related art solar cell module has a limitation in enhancement of light transmittance.

Thus, in order to solve the problem of the related art, a new approach to a structure of a solar cell module and a manufacturing method is required.

A solar cell module may be utilized as a sensor. The solar cell module utilized as a sensor may have a solar cell and is driven using electric power produced by the solar cell. Thus, the solar cell module utilized as a sensor may be used for the purpose of sensing a sensing target, without being limited to an installation place.

In spite of the advantages, however, the related art solar cell module has some problems to be solved.

In the related art, components such as a solar cell, a power source module, a communication module, and the like, are separately provided to form a single solar cell module to be utilized as a sensor, and the solar cell and other components are connected to each other by an electric cable. Thus, a connection structure of a cable for electrically connecting the solar cell and the other components is complicated and a large area is required to dispose the solar cell and the components. This leads to an increase in a size of a solar cell module, resultantly limiting an installation place of the solar cell module.

If the solar cell module, which is advantageously driven without being connected to a power cable, is limited in an installation place due to a size thereof, the strengths of the solar cell module cannot be sufficiently brought out, and thus, a design to reduce a size of the solar cell module is required.

US 2014/224299 A1 provides a method of producing a concentrating solar cell module on one surface of a base portion. The method includes a way of forming electric circuit on a back side of the base portion so that a use of a printed circuit board is not necessary.

US 2009/032087 A1 provides a method for manufacturing a light concentrating solar module on one surface of the backplane 14.

### [Disclosure]

### [Technical Problem]

Therefore, a first aspect of the detailed description is to provide a solar cell module having a configuration in which a component is automatically mounted. The present disclosure proposes a solar cell module having an encapsulant layer which is not melted or deformed during a process employing a high temperature surface-mount technology (SMT), with said encapsulant layer having light transmittance higher than a multilayer structure of a polymer protective layer and an EVA encapsulant layer, and forming an outermost layer.

A second aspect of the detailed description is to provide a method for manufacturing a solar cell module having the encapsulant layer mentioned in the first aspect.

The detailed description provides a sensor module in which both surfaces of a printed circuit board (PCB) are utilized for mounting a solar cell, a circuit component, and the like, as an example of a solar cell module. The manufacturing method is also disclosed.

One purpose of the detailed description is to provide a structure of a solar cell module simpler than that of a related art.

A second purpose of the detailed description is to provide a solar cell module not limited in an installation place.

Another purpose of the detailed description is to provide a structure of a solar cell module smaller than that of a related art, without reducing an installation area of a solar cell required to secure an area to receive light.

### [Technical Solution]

A solar cell module according to the present invention is provided in claim 1. A method for manufacturing a solar cell module is provided in claim 5.

The encapsulant layer may be formed to cover a solar cell or a primer layer to protect the solar cell. The silicone may have sufficient heat resistance even during a process employing a surface mount technology (SMT) at a high temperature of a maximum of 250°C. The primer layer may be formed between the solar cell and the encapsulant layer to strength bonding force between the solar cell and the encapsulant layer.

The solar cell module includes a solar cell mounted on a printed circuit board (PCB) and the encapsulant layer. The solar cell module may selectively include a dam layer forming edges of the encapsulant layer. The dam layer may be coupled to one surface of the PCB. The dam layer may serve to prevent a liquid encapsulant layer material from flowing to outside of the PCB during a process of manufacturing the solar cell module.

The liquid encapsulant layer material includes a curing agent for curing liquid silicone and may include a sunscreen to protect the solar cell from ultraviolet ray, as well as silicone.

The encapsulant layer may have high light transmittance in every light wavelength. The encapsulant layer has light transmittance of 80% or greater with respect to light having a wavelength of 300 nm, light transmittance of 91% to 93% with respect to light having a wavelength of 350 nm, and light transmittance of 93% to 94% with respect to light having a wavelength of 400 nm to 700 nm. Also, the encapsulant layer has light transmittance of 91 % to 94% with respect to visible light.

In order to protect the solar cell and have sufficient light transmittance, the encapsulant layer has a thickness ranging from 200*µ*m to 1,000*µ*m. The encapsulant layer may have a planar shape, may be uneven, or may have a dome shape.

The method of claim 5 for manufacturing a solar cell module includes: dispensing a liquid encapsulant layer material formed of a material including silicone and thermally curing the liquid encapsulant layer material.

The liquid encapsulant layer material may have viscosity of 10 Pa·s or less to have sufficient spreading characteristics.

The liquid encapsulant layer material may have viscosity of 40 Pa·s or less not to flow to outside of the PCB.

Conditions for thermally curing the encapsulant layer material may be varied depending on types of silicone included in the encapsulant layer material. When heat is applied to the encapsulant layer material at about 130°C to 170°C for 30 to 150 minutes, the encapsulant layer material may be cured to form an encapsulant layer.

The solar cell module manufactured thusly is free of a problem that the encapsulant layer is melted or deformed during a process of employing a surface mount technology (SMT) of mounting a component by applying heat at a high temperature in a furnace, and thus, the solar cell module may be mounted on a main PCB of an electronic device through the SMT. Here, a temperature of heat applied to the solar cell module during the process employing the SMT is 200°C to 250°C.

In the present claimed invention, both surfaces of the PCB are utilized for mounting a component such that a solar cell is stacked on a first surface of the PCB and a circuit component is mounted on a second surface of the PCB. Accordingly, an integrated sensor module may be realized. The first surface and the second surface face in mutually opposite directions, an electrode connection part is formed on the first surface and a circuit wiring is formed on the second surface. The solar cell and the encapsulant layer is mounted on the first surface and a sensor part and the circuit component may be mounted on the second surface.

The first surface may be disposed to face a direction in which light is supplied, and the solar cell required to receive light is mounted on the first surface and a circuit component not required to receive light is mounted on the second surface.

The PCB may have a multilayer structure, and a circuit wiring of the PCB may include an inner layer wiring formed within the multilayer structure and an outer layer wiring formed on an outer surface of the multilayer structure. The inner layer wiring and the outer layer wiring may be connected to each other through the multilayer structure and may also be connected to the electrode connection part of the first surface.

The sensor part may be selectively mounted on the first surface or the second surface of the main PCB depending on whether the sensor part is required to be exposed to light or an external environment. An infrared sensor, an ultrasonic sensor, and an illumination sensor are required to be exposed to light or an external environment, so these sensors may be mounted on the first surface. A temperature sensor, a humidity sensor, and a gas sensor are not required to be exposed to light or an external environment, and thus, these sensors may be mounted on the second surface.

A battery may be coupled to the second surface, electrically connected to a circuit wiring, and store electric power produced by the solar cell.

The PCB may be protected by a case and a window. A coupling part may be provided in the case, and the coupling part may be configured to fixate the PCB to the inside of the case.

### [Advantageous Effects]

In the present disclosure, since the size of the solar cell module is reduced, a limitation in an installation place of the solar cell module may be resolved.

### [Description of Drawings]

The accompanying drawings, which are included to provide a further understanding of the invention and are incorporated in and constitute a part of this specification, illustrate example embodiments and together with the description serve to explain the principles of the invention.

In the drawings:
FIGS. 1A and 1B are perspective views of a solar cell module of the present disclosure viewed in different directions, said solar cell module not being part of the claimed invention.
FIG. 2 is a cross-sectional view of a solar cell module of a first example which is not part of the claimed invention.
FIG. 3, which is not part of the claimed invention, is a cross-sectional view of a solar cell module according to a modification of the first example.
FIG. 4, which is not part of the claimed invention, is a cross-sectional view of a solar cell module according to another modification of the first example.
FIG. 5 is a cross-sectional view of a solar cell module of a second example which is not part of the claimed invention.
FIG. 6, which is not part of the claimed invention, is a cross-sectional view of a solar cell module according to a modification of the second example.
FIG. 7, which is not part of the claimed invention, is a cross-sectional view of a solar cell module according to another modification of the second example.
FIG. 8 is a graph illustrating light transmittance percentage of an encapsulant layer formed of a material including silicone by wavelengths.
FIG. 9 is a flow chart illustrating a process of manufacturing a solar cell module of the first example. .
FIGS. 10A to 10G are conceptual views illustrating a process of manufacturing a solar cell module according to the method of manufacturing a solar cell module illustrated in FIG. 9.
FIGS. 11A to 11H are cross-sectional views illustrating a process of manufacturing a solar cell module according to the method of manufacturing a solar cell module illustrated in FIG. 9.
FIG. 12 is a flow chart illustrating a process of manufacturing a solar cell module of the second example.
FIGS. 13A to 13E are conceptual views illustrating a process of manufacturing a solar cell module according to the method of manufacturing a solar cell module illustrated in FIG. 12.
FIGS. 14A to 14F are cross-sectional views illustrating a process of manufacturing a solar cell module according to the method of manufacturing a solar cell module illustrated in FIG. 12.
FIG. 15 is a flow chart illustrating a method of manufacturing an electronic device having a solar cell module.
FIGS. 16A and 16B are perspective views of a first embodiment of an integrated sensor module including a solar cell and a circuit component, viewed in different directions.
FIG. 17 is a cross-sectional view of a sensor module including a case and a window.
FIGS. 18A and 18B are perspective views of a second embodiment of an integrated sensor module including a solar cell and a circuit component, viewed in different directions.
FIG. 19 is a cross-sectional view of a sensor module including a case and a window.
FIG. 20 is a flow chart illustrating a method for manufacturing a sensor module according to the claimed invention.
FIGS. 21A to 21C are cross-sectional views illustrating a process of manufacturing a sensor module according to the method of manufacturing a sensor module illustrated in FIG. 20.
FIG. 22 is a flow chart illustrating another method of manufacturing a sensor module according to the claimed invention.
FIGS. 23A to 23C are cross-sectional views illustrating a process of manufacturing a sensor module according to the method of manufacturing a sensor module illustrated in FIG. 22.
FIG. 24 is a perspective view illustrating a sensor module of the present disclosure, said solar cell module not being part of the claimed invention.
FIG. 25, which is not part of the claimed invention, is a perspective view illustrating components accommodated within a case.
FIG. 26, which is not part of the claimed invention, is a cross-sectional view of a sensor module.
FIGS. 27A to 27C are conceptual views illustrating an example of a method for manufacturing a sensor module, said method not being part of the claimed invention.
FIGS. 28A to 28E are conceptual views illustrating another example of a method for manufacturing a sensor module, said method not being part of the claimed invention.
FIG. 29 is a perspective view illustrating another embodiment of a sensor module.
FIG. 30 is a perspective view illustrating another example of a sensor module, said sensor module not being part of the claimed invention.

### [Mode for Invention]

Description will now be given in detail with reference to the accompanying drawings. For the sake of brief description with reference to the drawings, the same or equivalent components will be provided with the same reference numbers, and description thereof will not be repeated.

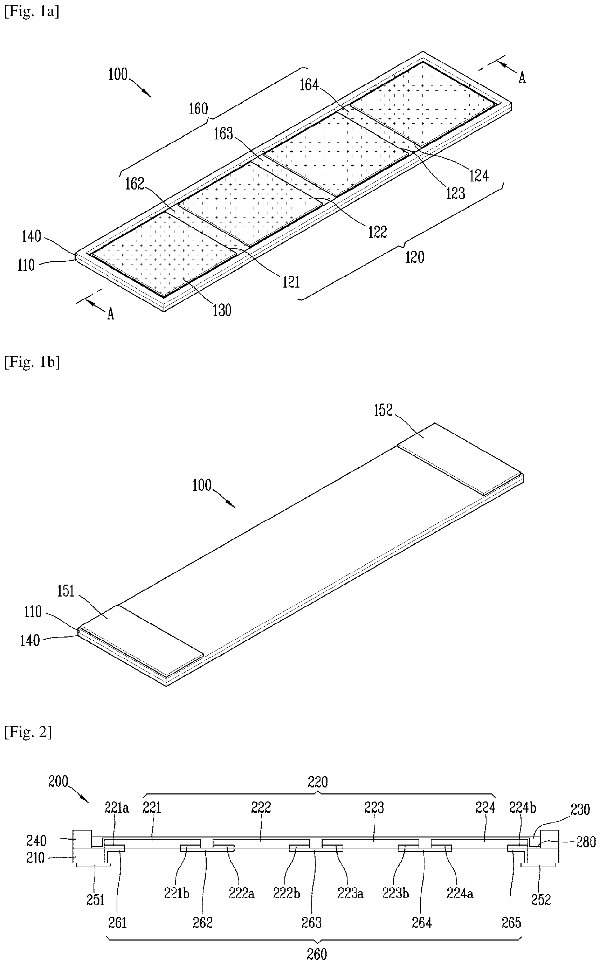

FIGS. 1A and 1B are perspective views of a solar cell module of the present disclosure viewed in different directions, said solar cell module not being part of the claimed invention.

A solar cell module 100 refers to a module having a solar cell 120 to produce electric power from light. A module refers to a constituent unit of a machine or a system and represents an independent unit assembled to several electronic components or mechanical components to have a specific function. Thus, the solar cell module 100 may be understood as indicating an independent unit having a solar cell 120 and having a function of producing electric power from light.

The solar cell module 100 includes a printed circuit board (PCB) 110, a solar cell 120, an encapsulant layer 130, a dam layer 140, output terminals 151 and 152, and an electrode connection part 160. Hereinafter, the components will be described in detail.

The PCB 110 supports the entirety of the solar cell module 100 and is electrically connected to the solar cell 120. The PCB 110 is formed of an insulating material. An electrode part of the solar cell 120 and the electrode connection part 160 of the PCB 110 are electrically connected, while a region other than a region in which the electrode connection part 160 is formed is electrically insulated by an insulating material.

The PCB 110 has a first surface and a second surface which face in the opposite directions. The first surface may be referred to as a front surface or an upper surface, and the second surface may be referred to as a rear surface or a lower surface. The electrode connection part 160 electrically connected to the solar cell 120 is exposed to the first surface, and output terminals 151 and 152 outputting power collected from the solar cell 120 are exposed to the second surface. However, alternatively, the output terminals 151 and 152 may be exposed to the first surface of the PCB 110, unlike those illustrated in FIG. 1B.

The electrode connection part 160 is configured to connect a plurality of solar cells 121, 122, 123, and 124 in series. For example, a plurality of electrode connection parts 162, 163, and 164 are disposed between the solar cells 121, 122, 123, and 124, and each of the electrode connection units 162, 163, and 164 electrically connect two adjacent solar cells 121 and 122, 122 and 123, and 123 and 124. The electrode connection unit 160 is electrically connected to the output terminals 151 and 152.

The solar cell 120 is mounted on the PCB 110 and an electrode part of the solar cell 120 is electrically connected to the electrode connection unit 160 of the PCB 110. The solar cell 120 may be mounted on a first surface of the PCB 110 partially converts the electrode connection unit 160 formed on the first surface of the PCB 110. An electrical connection structure of the electrode part of the solar cell 120 and the electrode connection part 160 of the PCB 110 will be described hereinafter with reference to FIGS. 2 to 7.

One solar cell module may have a plurality of solar cells 121, 122, 123, and 124. The plurality of solar cells 121, 122, 123, and 124 may be dispose to be spaced apart from each other on the same planar surface. The plurality of solar cells 121, 122, 123, and 124 may be connected in series to each other by the electrode connection parts 162, 163, and 164. In FIG. 1, it is illustrated that four solar cells 121, 122, 123, and 124 are provided in the single solar cell module 100, but the number and disposition of the solar cells 121, 122, 123, and 124 may be varied depending on a design of the solar cell module 100.

The solar cell 120 is configured to convert light energy into electrical energy. In general, the solar cell 120 is formed of a P type semiconductor and an N type semiconductor and when light is applied to the solar cell 120, electric charges migrate to generate a potential difference.

A structure in which two electrodes of each solar cell 120 are all formed on the opposite surface of a light receiving surface (or a light collecting surface) of the solar cell 120 may be termed a back contact structure. It can be seen that two electrodes of each of the solar cells 121, 122, 123, and 124 are all formed on the opposite surface of the light receiving surface in that the solar cells 121, 122, 123, and 124 illustrated in FIGS. 1A and 1B are connected in series to each other by the electrode connection parts 162, 163, and 164. Thus, the solar cells 121, 122, 123, and 124 illustrated in FIGS. 1A and 1B are classified as solar cells having a back contact structure.

In contrast, a structure in which one electrode is formed on each of a light receiving surface and an opposite surface of a solar cell is classified as a general structure. In the general structure, an electrode of a certain solar cell and an electrode of another solar cell adjacent to the certain solar cell (the two electrodes have the opposite polarities) are connected in series by a separate conductor.

The encapsulant layer 130 covers the solar cell 120 to protect the solar cell 120 from external impact, moisture, and the like. In cases where the solar cells 121, 122, 123, and 124 are provided in plurality, the encapsulant layer 130 may cover all of the plurality of solar cells 121, 122, 123, and 124.

The encapsulant layer 130 is transparent. Since the solar cell 120 produces electric power using light, an amount of light transmitted to the solar cell 120 may be increased as transparency of the encapsulant layer 130 is increased.

A primer layer may be formed between the encapsulant layer 130 and the solar cell 120 to bond the encapsulant layer 130 to the solar cell 120. However, in cases where the encapsulant layer 130 is adhesive, the encapsulant layer 130 may not be separated from the solar cell 120, even without the primer layer. Thus, the primer layer is optional, and not essential to the solar cell module 100.

In order to solve the problem of the related art solar cell module, the encapsulant layer 130 of the present disclosure is formed of a material including silicone.

The material including silicone refers to a material including any other material in addition to silicone. Here, the other material includes, for example, a curing agent for curing liquid silicone during a process of manufacturing the solar cell module 100, a sunscreen for blocking ultraviolet ray incident to the solar cell, and an adhesive providing adhesion to the encapsulant layer. In the present disclosure, types of the curing agent, sunscreen, and adhesive are not particularly limited.

Silicone has high heat resistance, relative to a polymer protective layer and an ethylene-vinyl acetate copolymer (EVA) adhesive layer. Thus, the solar cell module 100 having the encapsulant layer 130 formed of a material including silicone does not cause melting or deformation of the encapsulant layer 130 even in a process of applying a high temperature surface-mount technology (SMT). A temperature of the process of applying the SMT is a maximum of 250°C and silicone has sufficient heat resistance at the temperature.

Thus, according to the present disclosure having the encapsulant layer 130 formed of a material including silicone, it is possible to mount a circuit component by applying a high temperature SMT to the PCB 110 of the solar cell module 100, as well as mounting the solar cell module 100 on a main PCB (a separate component on which the solar cell module 100 is to be mounted) by applying the high temperature SMT.

The solar cell module 100 of the present disclosure has an outermost layer formed of the silicone encapsulant layer 130 on the solar cell 120. Unlike the related art solar cell module having the encapsulant layer and the protective layer, the silicone encapsulant layer 130 also has a function of a protective layer, and thus, the solar cell module 100 of the present disclosure does not require a separate protective layer on the silicone encapsulant layer 130.

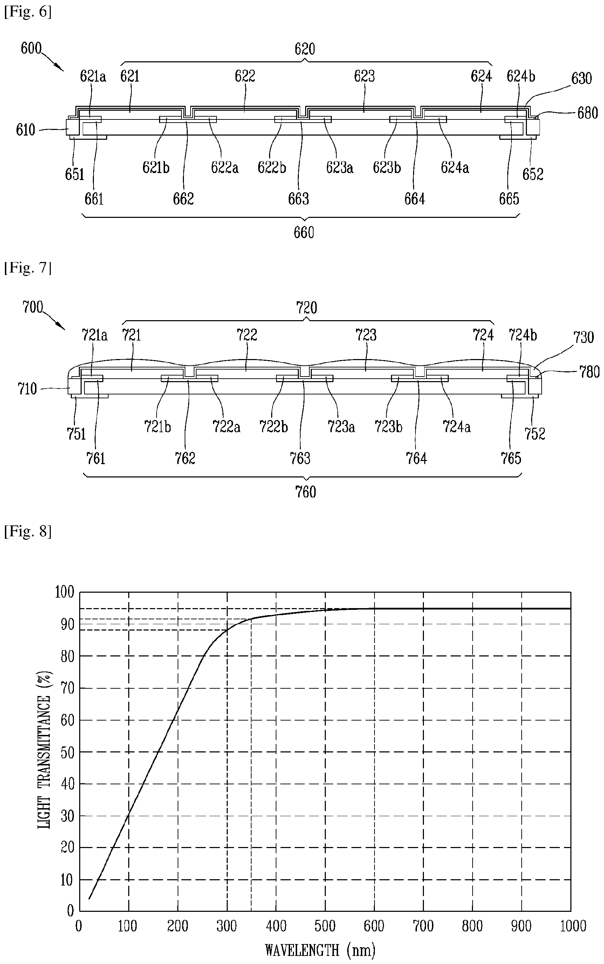

Compared with a case in which an encapsulant layer and a protective layer are separately provided, the outermost layer formed only on the silicone encapsulant layer 130 may realize a more reduced thickness. Thus, compared with the related art, in the present disclosure, an amount of light reaching the solar cell 120 may be increased, and thus, efficiency of the solar cell module 100 may be enhanced. Such an effect relates to light transmittance of the silicone encapsulant layer 130 as described hereinafter with reference to FIG. 8 .

The encapsulant layer 130 has a thickness ranging from 200 to 1,000*µ*m. If the thickness of the encapsulant layer 130 is smaller than 200*µ*m, it is difficult to sufficiently protect the solar cell 120. Thus, in order to protect the solar cell 120, the encapsulant layer 130 has a thickness of 200*µ*m or greater. Conversely, if the thickness of the encapsulant layer 130 exceeds 1,000*µ*m, light transmittance is degraded to lower efficiency of the solar cell module 100. Thus, preferably, the thickness of the encapsulant layer 130 does not exceed 1,000*µ*m.

The dam layer 140 is coupled to one surface of the PCB 110. One surface of the PCB 110 indicates a surface on which the solar cell 120 and the encapsulant layer 130 are formed. As mentioned above, opposing surfaces of the PCB 110 are divided into the first surface and the second surface and the solar cell 120 and the encapsulant layer 130 are formed on the first surface. According to the descriptions, the dam layer 140 is coupled to the first surface of the PCB 110.

The dam layer 140 is formed on the edges of the encapsulant layer 130. The dam layer 140 supports the edges of the encapsulant layer 130 and protects the solar cell 120 and the edges of the encapsulant layer 130.

The dam layer 140 serves to prevent a liquid encapsulate layer material from flowing to an outer side of the PCB 110 during a process of manufacturing the solar cell module 100. Thus, when the liquid encapsulant layer material has sufficiently high viscosity, the dam layer 140 is not required and, and in this case, the dam layer 140 may be not be essential but optional.

Hereinafter, various structures of the solar cell module will be described. Cross-sectional views of the solar cell module illustrated in FIGS. 2 to 7 are cross-sectional views of the solar cell module, taken along line A-A of FIG. 1, and viewed from one side.

FIG. 2 is a cross-sectional view of a solar cell module 200 of a first example which is not part of the claimed invention.

A PCB 210 includes an electrode connection part 260 and the electrode connection parts 260 are exposed to a first surface of the PCB 210. The electrode connection parts 260 are disposed to be spaced apart from each other and connect solar cells 221, 222, 223, and 224 in series. The solar cells 221, 222, 223, and 224 have two electrodes 221a and 221b, 222a and 222b, 223a and 223b, and 224a and 224b, having the opposite polarities, respectively.

Referring to FIG. 2, when the solar cell module 200 includes four solar cells 221, 222, 223, and 224, five electrode connection parts 261, 262, 263, 264, and 265 are formed to connect four solar cells 221, 222, 223, and 224 in series, and among them, three electrode connection parts 262, 263, and 264 are disposed between two solar cells 221 and 222, between solar cells 222 and 223, and between solar cells 223 and 224. For the purposes of description, four solar cells 221, 222, 223, and 224 are referred to as first to fourth solar cells 221, 222, 223, and 224, and five electrode connection parts 261, 262, 263, 264, and 265 may be referred to as first to fifth electrode connection parts 261, 262, 263, 264, and 265.

The first solar cell 221 has electrode parts 221a and 221b including a negative electrode 221a and a positive electrode 221b, and the negative electrode 221a and the positive electrode 221b are disposed to be spaced apart from each other on the opposite surface of a light receiving surface. When the first solar cell 221 is mounted on the PCB 210, the negative electrode 221a is connected to the first electrode connection part 261 and the positive electrode 221b is connected to the second electrode connection part 262.

The second solar cell 222 has electrode parts 222a and 222b including a negative electrode 222a and a positive electrode 222b, and the negative electrode 222a and the positive electrode 222b are disposed to be spaced apart from each other on the opposite surface of a light receiving surface. When the second solar cell 222 is mounted on the PCB 210, the negative electrode 222a is connected to the second electrode connection part 262 and the positive electrode 222b is connected to the third electrode connection part 263.

The third solar cell 223 has electrode parts 223a and 223b including a negative electrode 223a and a positive electrode 223b, and the negative electrode 223a and the positive electrode 223b are disposed to be spaced apart from each other on the opposite surface of a light receiving surface. When the third solar cell 223 is mounted on the PCB 210, the negative electrode 223a is connected to the third electrode connection part 263 and the positive electrode 223b is connected to the fourth electrode connection part 264.

The fourth solar cell 224 has electrode parts 224a and 224b including a negative electrode 224a and a positive electrode 224b, and the negative electrode 224a and the positive electrode 224b are disposed to be spaced apart from each other on the opposite surface of a light receiving surface. When the fourth solar cell 224 is mounted on the PCB 210, the negative electrode 224a is connected to the fourth electrode connection part 264 and the positive electrode 224b is connected to the fifth electrode connection part 265.

The electrode connection parts 261, 262, 263, 264, and 265 and output terminals 251 and 252 formed on the second surface of the PCB 210 are electrically connected to each other. A structure such as a through hole or a via hole may be formed on the PCB 210, and the electrode connection parts 261 and 265 at both ends are connected to the output terminals 251 and 252 by a wiring passing through the through hole or the via hole. For example, the first electrode connection part 261 is connected to the output terminal 251 on one side and the fifth electrode connection part 265 is connected to the output terminal 252 on the other side. The wiring excluding the electrode connection parts may be formed within the PCB 210.

The plurality of solar cells 221, 222, 223, and 224 are mounted on the first surface of the PCB 210, and an encapsulant layer 230 is disposed on the plurality of solar cells 221, 222, 223, and 224 to protect the plurality of solar cells 221, 222, 223, and 224. An upper surface of the encapsulant layer 230 illustrated in FIG. 2 has a planar structure.

A primer layer 280 for strengthening adhesion may be provided between the solar cell 220 and the encapsulant layer 230. The primer layer 280 is configured to bond the encapsulant layer 230 to the solar cell 220. However, as mentioned above, the primer layer 280 is not essential to the solar cell module 200.

A dam layer 240 is provided on the edges of the PCB 210. The dam layer 240 has a height higher than a side surface of the encapsulant layer 230 to define a region of the encapsulant layer 230. An outer boundary of the solar cell module 200 may be formed by the dam layer 240.

FIG., which is not part of the claimed invention, is a cross-sectional view of a solar cell module 300 according to a modification of the first example.

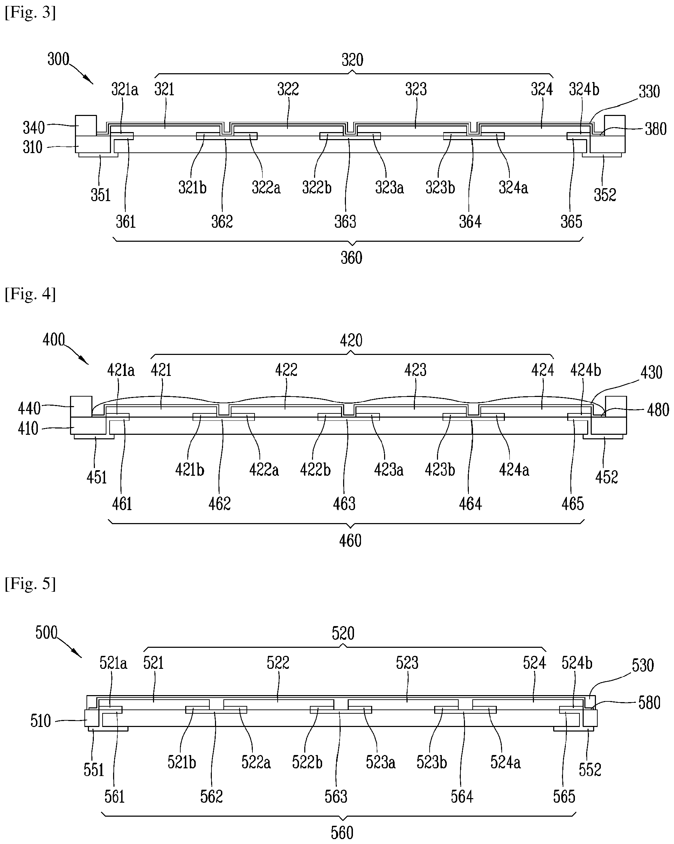

The solar cell module 300 illustrated in FIG. 3 has the same structure as that of the solar cell module 200 illustrated in FIG. 2, except a structure of an encapsulant layer 330. Compared with the encapsulant layer 230 of the solar cell module 200 illustrated in FIG. 2, having a planar structure, the encapsulant layer 330 of the solar cell module 300 illustrated in FIG. 3 partially has a concavo-convex portion.

The concavo-convex portion of the encapsulant layer 330 is formed on the edges of the solar cells 321, 322, 323, and 324. For example, the concavo-convex portion may be formed at a left end portion and a right end portion of the solar cell 320 and between the solar cells 321 and 322, between the solar cells 322 and 323, and between the solar cells 323 and 324.

When the encapsulant layer 330 has the concavo-convex portion, a thickness of the encapsulant layer 330 is thinner than the planar encapsulant layer 230 of FIG. 2, and thus, light transmittance of the encapsulant layer 330 is increased. Thus, an amount of light incident to the solar cell 320 may be increased and efficiency of the solar cell module 300 may be increased.

Components not described in FIG. 3 may be referred to the descriptions of FIG. 2. Reference numeral 310 not described in FIG. 3 denotes a PCB, 321 to 324 denote first to fourth solar cells, 340 denotes a dam layer, and 351 and 352 denote output terminals. Also, reference numeral 360 denotes an electrode connection part, 361 to 365 denote first to fifth electrode connection parts, and 380 denotes a primer layer.

FIG. 4, which is not part of the claimed invention, is a cross-sectional view of a solar cell module 400 according to another modification of the first example.

The solar cell module 400 illustrated in FIG. 4 has the same structure as that of the solar cell module 200 illustrated in FIG. 2, except a structure of an encapsulant layer 430. Compared with the encapsulant layer 230 of the solar cell module 200 illustrated in FIG. 2, having a planar structure, the encapsulant layer 430 of the solar cell module 400 illustrated in FIG. 4 partially has a circular shape, like a dome shape, rather than a planar structure.

A thickness of the encapsulant layer 430 is most thick in a position facing the middle portion of each of the solar cells 421, 422, 423, and 424 and is reduced toward left and right ends of each of the solar cells 421, 422, 423, and 424. The thickness of the encapsulant layer 430 is most thin at left and right ends of each of the solar cells 421, 422, 423, and 424 and between two solar cells 421 and 422, between two solar cells 422 and 423, and between two solar cells 423 and 424.

When the thickness of the encapsulant layer 430 is increased, light transmittance of the encapsulant layer 430 may be slightly lowered, but the solar cell 420 may be more stably protected from a physical external force. A physical external force applied to the solar cell 420 is highly likely to concentrate largely on a middle portion, rather than on left and right ends of each of the solar cells 421, 422, 423, and 424. Thus, when the thickness of the encapsulant layer 430 is thick in the position facing a middle portion of each of the solar cells 421, 422, 423, and 424, the solar cells 421, 422, 423, and 424 may be sufficiently protected. Also, when the thickness of the encapsulant layer 430 is reduced at left and right ends of each of the solar cells 421, 422, 423, and 424, a degradation of light transmittance may be slightly restrained.

Components not described in FIG. 4 may be referred to the descriptions of FIG. 2. In FIG. 4, reference numeral 410 not described in FIG. 3 denotes a PCB, 421 to 424 denote first to fourth solar cells, 440 denotes a dam layer, and 451 and 452 denote output terminals. Also, reference numeral 460 denotes an electrode connection part, 461 to 465 denote first to fifth electrode connection parts, and 480 denotes a primer layer.

FIG. 5 is a cross-sectional view of a solar cell module 500 of a second example which is not part of the claimed invention.

The solar cell module 500 illustrated in FIG. 5 has the same structure as that of the solar cell module 200 illustrated in FIG. 2, except that the solar cell module of FIG. 5 has dam layers 240, 340, and 440 (please refer to FIGS. 2 to 4). The dam layers serve to prevent a liquid encapsulant layer material from flowing to an outer of a PCB during a process of curing the liquid encapsulant layer material to form an encapsulant layer.

If the liquid encapsulant layer material has sufficiently high viscosity, it may not flow to the outside of the PCB 510. Thus, in cases where the encapsulant layer 530 is formed of an encapsulant layer material with sufficiently high viscosity, the solar cell module 500 may be manufactured without a dam layer. The sufficiently high viscosity will be described hereinafter.

Without the dam layer at the edges of the encapsulant layer 530, a size of the solar cell module 500 may be reduced even it has the solar cells 521, 522, 523, and 524 having the same area. For example, the solar cell module 500 illustrated in FIG. 5 is smaller than the solar cell module 200 illustrated in FIG. 2 by a width of the dam layer 240.

Efficiency of the solar cell module 500 is determined on the basis of an overall size of the solar cell module 500. Thus, when the solar cell module 500 has the solar cells 521, 522, 523, and 524 having the same area, the solar cell module 500 has higher efficiency as a size thereof is reduced. Thus, when the size of the solar cell module 500 is reduced by the width of the dam layer, efficiency of the solar cell module 500 may be enhanced by the corresponding ratio.

Components not described in FIG. 5 may be referred to the descriptions of FIG. 2. In FIG. 5, 521 to 524 denote first to fourth solar cells and 551 and 552 denote output terminals. Also, reference numeral 560 denotes an electrode connection part, 561 to 565 denote first to fifth electrode connection parts, and 580 denotes a primer layer.

FIG. 6, which is not part of the claimed invention, is a cross-sectional view of a solar cell module 500 according to a modification of the second example.

The solar cell module 600 illustrated in FIG. 6 has the same structure as that of the solar cell module 500 illustrated in FIG. 5, except a structure of an encapsulant layer 630. Compared with the encapsulant layer 530 of the solar cell module 500 illustrated in FIG. 5, having the planar structure, the encapsulant layer 630 of the solar cell module 600 illustrated in FIG. 6 partially has a concavo-convex portion overall.

The concavo-convex portion of the encapsulant layer 630 is formed at edges of each of the solar cells 621, 622, 623, and 624. For example, a concavo-convex portion may be formed at a left end portion and a right end portion of each of the solar cells 621, 622, 623, and 624, and between two solar cells 621 and 622 and two solar cells 622 and 623, and between two solar cells 623 and 624.

When the encapsulant layer 630 has the concavo-convex portion, a thickness of the encapsulant layer 630 is thinner than a planar encapsulant layer, and thus, light transmittance of the encapsulant layer 630 is increased. Thus, an amount of light incident to the solar cell 620 may be increased and efficiency of the solar cell module 600 may be increased.

Components not described in FIG. 6 may be referred to the descriptions of FIG. 5. Reference numeral 610 not described in FIG. 6 denotes a PCB, 621 to 624 denote first to fourth solar cells, and 651 and 652 denote output terminals. Also, reference numeral 660 denotes an electrode connection part, 661 to 665 denote first to fifth electrode connection parts, and 680 denotes a primer layer.

FIG. 7, which is not part of the claimed invention, is a cross-sectional view of a solar cell module 700 according to another modification of the second example.

The solar cell module 700 illustrated in FIG. 7 has the same structure as that of the solar cell module 500 illustrated in FIG. 5, except a structure of an encapsulant layer 730. Compared with the encapsulant layer 530 of the solar cell module 500 illustrated in FIG. 5, having a planar structure, the encapsulant layer 730 of the solar cell module 700 illustrated in FIG. 4 partially has a circular shape, like a dome shape, rather than a planar structure.

A thickness of the encapsulant layer 730 is most thick in a position facing the middle portion of each of the solar cells 721, 722, 723, and 724 and is reduced toward left and right ends of each of the solar cells 721, 722, 723, and 724. The thickness of the encapsulant layer 730 is most thin at left and right ends of each of the solar cells 721, 722, 723, and 724 and between two solar cells 721 and 722, between two solar cells 722 and 723, and between two solar cells 723 and 724.

In a region where the thickness of the encapsulant layer 730 is large, light transmittance of the encapsulant layer 730 may be slightly lowered but the solar cell may be more stably protected from a physical external force.

Components not described in FIG. 7 may be referred to the descriptions of FIG. 5. In FIG. 7, reference numeral 710 not described in FIG. 7 denotes a PCB, 721 to 724 denote first to fourth solar cells, 751 and 752 denote output terminals. Also, reference numeral 760 denotes an electrode connection part, 761 to 765 denote first to fifth electrode connection parts, and 780 denotes a primer layer.

FIG. 8 is a graph illustrating light transmittance percentage of an encapsulant layer formed of a material including silicone by wavelengths.

In the graph, the horizontal axis represents wavelength (nm) of light incident to a solar cell, and the vertical axis represents light transmittance (%) of encapsulant layer.

A solar cell module is configured to produce electric power using light incident to a solar cell. Thus, as light transmittance of an encapsulant layer covering the solar cell is higher, efficiency of the solar cell module is higher. However, UV light having strong energy, relative to visible light or infrared light, may damage the solar cell. For this reason, the encapsulant layer may include a sunscreen.

Referring to the graph of FIG. 8, light transmittance of the encapsulant layer is gradually increased as a wavelength of light is increased, and is relatively uniform from a wavelength of about 600 nm.

The encapsulant layer formed of silicone has light transmittance of 80% or greater with respect to light having a wavelength of 300 nm, and more strictly, has light transmittance of 85% or greater. Compared with a polymer protective layer and an EVA bonding layer having light transmittance lower than 80% with respect to light having a wavelength of 300 nm, light transmittance of the encapsulant layer formed of silicone is high.

Also, the encapsulant layer formed of a material including silicone has light transmittance of 91% to 93% with respect to light having a wavelength of 350 nm. Compared with light transmittance of the polymer protective layer and the EVA bonding layer having light transmittance lower than 91% with respect to light having a wavelength of 350 nm, the light transmittance of the encapsulant layer formed of a material including silicone is high.

Also, the encapsulant layer formed of a material including silicone has light transmittance of 93% to 94% with respect to light having a wavelength of 400 nm to 780 nm. Compared with the polymer protective layer and the EVA bonding layer having light transmittance lower than 91% with respect to light having a wavelength of 400 nm to 780 nm, light transmittance of the encapsulant layer formed of a material including silicone is high.

Also, the encapsulant layer formed of a material including silicone has light transmittance of 91% to 94% with respect to visible light. A wavelength range in which a human being may feel or perceive light with his eyes may be slightly different by persons so it may be difficult to clearly determine a range of visible light, but light having a wavelength of about 380 nm to 800 nm corresponds to visible light. Compared with the polymer protective layer and the EVA bonding layer having light transmittance lower than 91% with respect to visible light, light transmittance of the encapsulant layer formed of a material including silicone is high.

To sum up, the encapsulant layer formed of a material including silicone has light transmittance higher than that of the polymer protective layer and the EVA bonding layer in every wavelength. Thus, since the encapsulant layer increases an amount of light incident to the solar cell, relative to the polymer protective layer and the EVA bonding layer, a solar cell module having efficiency higher than that of the related art may be realized.

Hereinafter a method for manufacturing the solar cell module described above will be described.

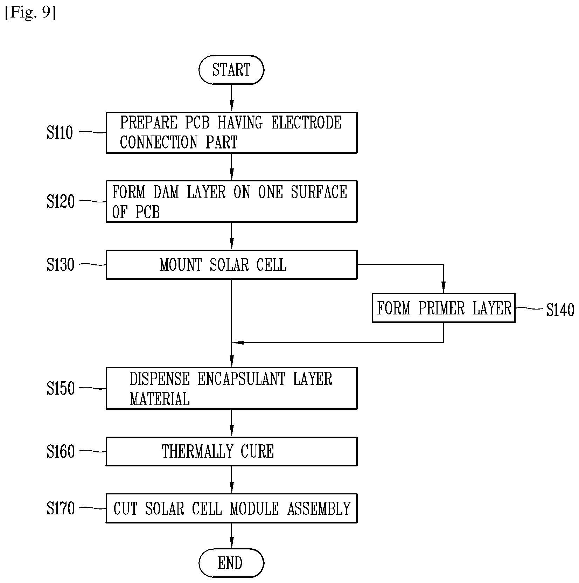

FIG. 9 is a flow chart illustrating a process of manufacturing solar cell modules (200, 300, and 400 of FIGS. 2 to 4) of the first example.

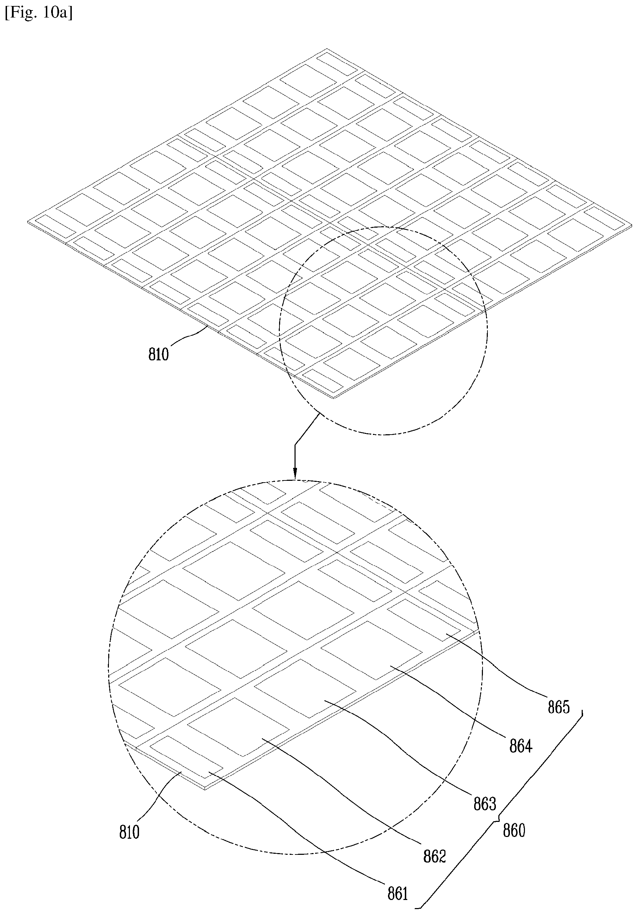

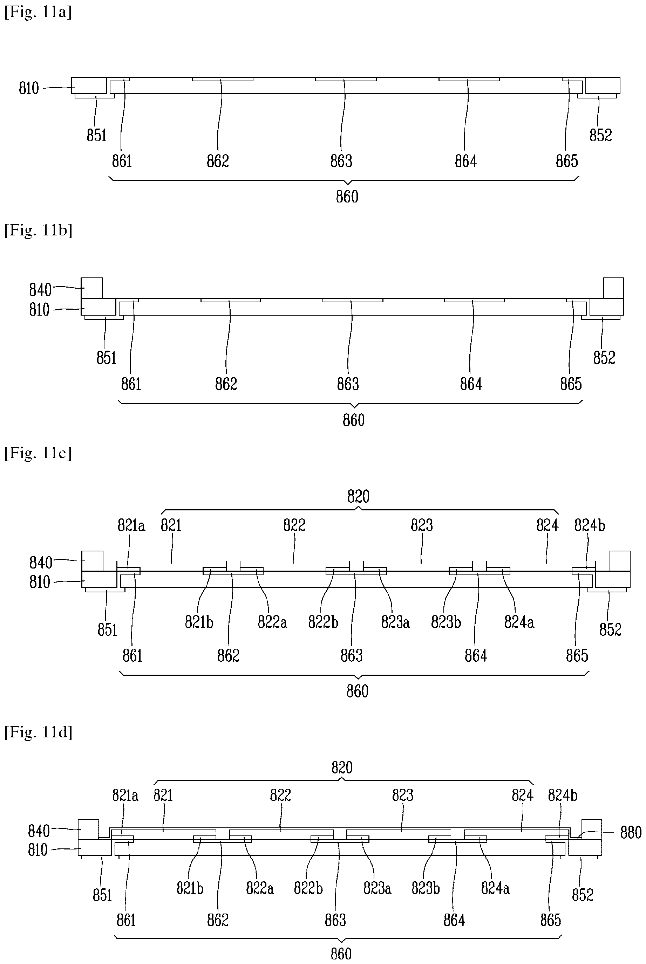

FIGS. 10A to 10G are conceptual views illustrating a process of manufacturing a solar cell module according to the method of manufacturing a solar cell module illustrated in FIG. 9. FIGS. 11A to 11H are cross-sectional views illustrating a process of manufacturing a solar cell module according to the method of manufacturing a solar cell module illustrated in FIG. 9.

FIGS. 10A to 10G illustrate a process of manufacturing a plurality of solar cell modules, and FIGS. 11A to 11H illustrate a process of manufacturing one of a plurality of solar cell modules.

Referring to FIG. 9, in order to manufacture a solar cell module, first, a PCB 810 having an electrode connection part is prepared (S110). FIGS. 10A and 11A correspond to step S110 of FIG. 9.

Referring to FIG. 10A, the PCB 810 is divided into a plurality of regions, and an electrode connection part 860 is formed in each of the regions. The electrode connection part 860 may have been solder-processed. Wirings other than the electrode connection part 860 may be formed within the PCB 810.

The electrode connection part 860 includes a first electrode connection part 861 to a fifth electrode connection part 865. The first electrode connection part 861 to the fifth electrode connection part 865 are disposed to be spaced apart from each other. The number of the electrode connection parts 861, 862, 863, 864, and 865 may be varied depending on a design of a solar cell module.

In FIG. 10A, a first surface of the PCB 810 is illustrated, and a second surface of the PCB 810 is illustrated in FIG. 11A. Referring to FIG. 11A, the electrode connection part 860 is exposed to the first surface of the PCB 810, and output terminals 851 and 852 are formed on the second surface of the PCB 810. As illustrated in FIG. 11A, the output terminals 851 and 852 may be formed on one side and the other side of the second surface. Alternatively, the output terminals 851 and 852 may be formed abreast on the second surface, and both the output terminals 851 and 852 may be formed on the first surface or the output terminals 851 and 852 may respectively be formed on the first surface and the second surface.

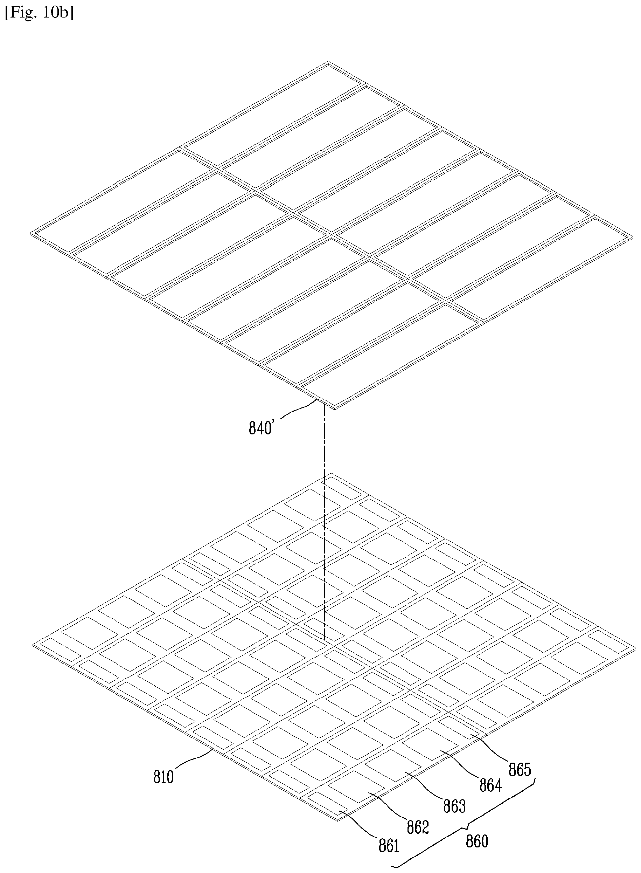

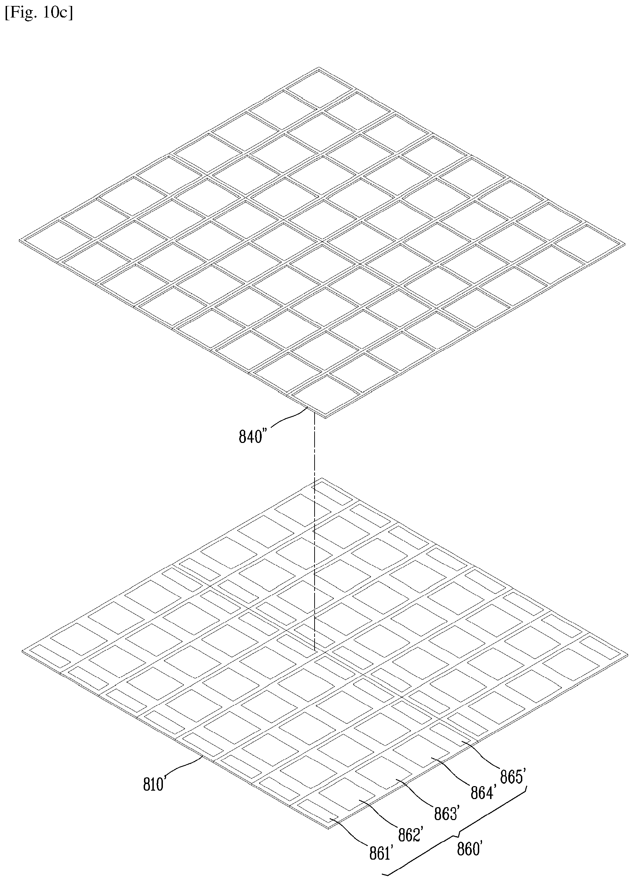

Referring back to FIG. 9 , a dam layer is formed on one surface of the PCB. One surface of the PCB refers to a first surface on which a solar cell is to be mounted. FIGS. 10B, 10C, and 11B correspond to step S120 of FIG. 9.

Referring to FIG. 10B, the dam layer is formed by attaching a unit grid assembly 840' on the first surface of the PCB 810. A size of the unit grid assembly 850' corresponds to the PCB 810, and each of unit grids has a size of corresponding to a unit size of a solar cell module. A hole is formed in each of the unit grids and each of the unit grids forms an edge of the hole. Also, a plurality of unit grids gather to form a single assembly 840'.

FIG. 10C is a modification of FIG. 10B. Referring to FIG. 10C, unit grids of a unit grid assembly 840" are formed to have a size covering each solar cell to be mounted on the PCB 810. Each unit grid is formed at every edge of a solar cell. A boundary is formed by the unit grid assembly 840" between solar cells.

The unit grid assemblies 840' and 840" may be bonded to the PCB 810 by an adhesive.

The unit grid assemblies 840' and 840" may be formed of the same material as that of the PCB 810. For example, the unit grid assemblies 840' and 840" and the PCB 810 may be formed of a glass epoxy called an FR4 (frame retardant). Also, the unit grid assemblies 840' and 840" and the PCB 810 may be formed of at least one of various materials such as ceramics, a metal, and the like.

Referring to FIG. 11B, as the unit grid assembly is bonded to a first surface of the PCB 810, a dam layer 840 is formed. The unit grid is formed at an edge of the PCB 810.

Since a hole is formed in the unit grid, the first surface of the PCB 810 on which a solar cell is to be mounted is partially exposed through the unit grid. The region exposed through the unit grid may be referred to as an exposed region of the PCB 810.

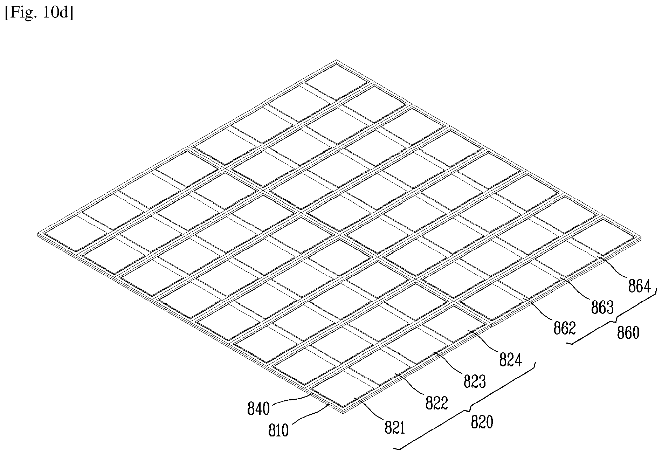

Referring back to FIG. 9, at least one solar cell is mounted in each exposed region of the PCB exposed through unit grids (S130). A solar cell is mounted on the first surface of the PCB, and the number of solar cells may be varied depending on a design of a solar cell module. FIGS. 10D and 11C correspond to step S130 of FIG. 9 .

Referring to FIG. 10D, four solar cells 821, 822, 823, and 824 are respectively mounted in exposed regions of the PCB 810 exposed through unit grids. Referring to FIG. 11C, the solar cells 821, 822, 823, and 824 are disposed to be spaced apart from each other. Electrode connection parts 860 formed on the PCB 810 and electrode parts 821a, 821b, 822a, 822b, 823a, 823b, 824a, and 824b of the solar cell 820 are physically in contact with each other. The step of forming the dam layer 840 and the step of mounting the solar cell 820 may be reversed in order.

Referring back to FIG. 9, a primer layer is formed on the solar cell (S140). The primer layer serves to bond an encapsulant layer to the solar cell. FIG. 11D corresponds to step S140 of FIG. 9.

Referring to FIG. 11D, a primer layer 880 is formed on the solar cells 821, 822, 823, and 824. In step S140 of forming the primer layer 880, a primer material is sprayed to the solar cells 821, 822, 823, and 824 and thermally cured. Here, thermally curing the primer material is performed such that the primer material is heat-treated at temperatures 90°C to 110°C for 20 to 40 minutes.

However, in the solar cell module, the primer layer 880 is not essential, and thus, step S140 of forming a primer layer is not essential in the method of manufacturing a solar cell module. Thus, step S140 of forming a primer layer may be omitted and step S150 of dispensing an encapsulant layer material may be performed immediately after step S130 of mounting a solar cell.

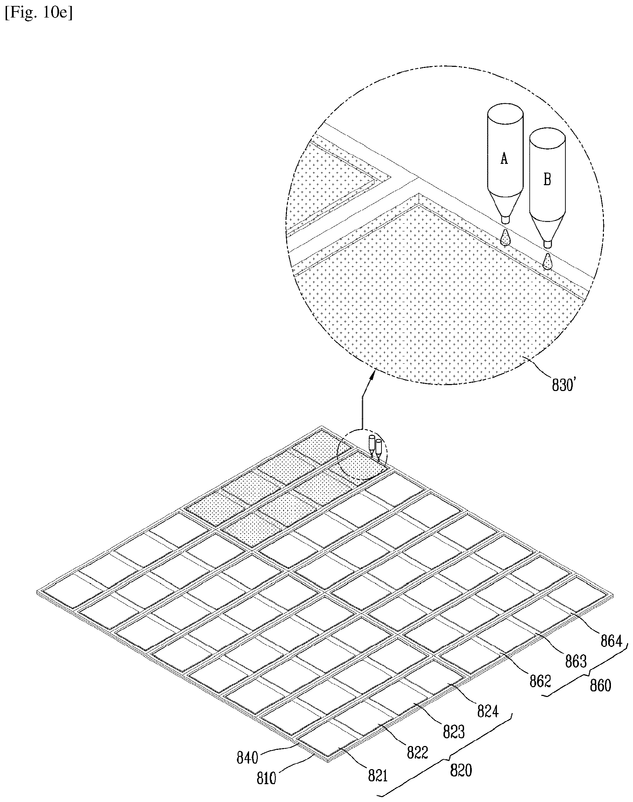

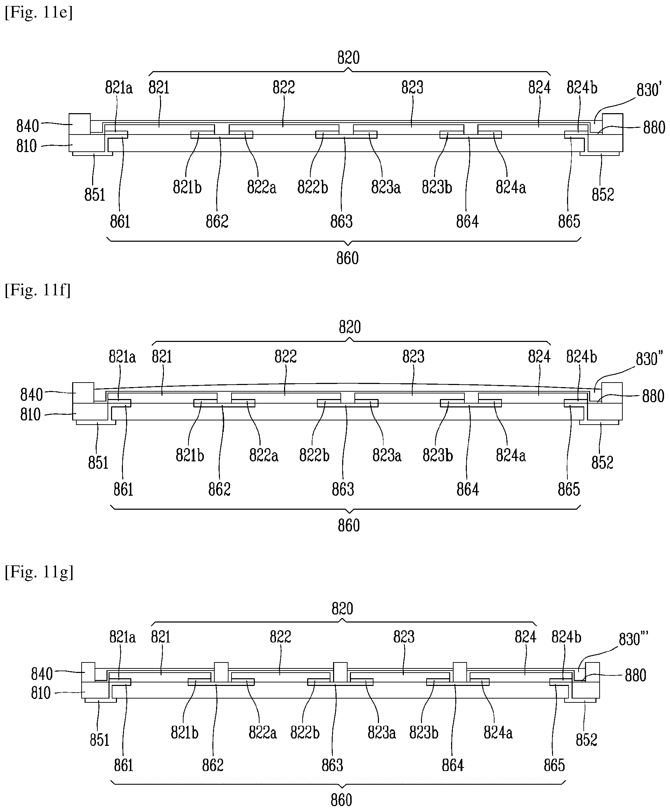

Referring back to FIG. 9, a liquid encapsulant layer material is dispensed (S150) after step S130 of mounting a solar cell or after step S140 of forming a primer layer. Without the primer layer, the encapsulant layer material is dispensed to the solar cell, and with the primer layer, the encapsulant layer material is dispensed to the primer layer. FIGS. 10E, 11E, 11F, and 11G correspond to step S150 of FIG. 9.

The liquid encapsulant layer material 830' includes silicone and may additionally include a curing agent, a sunscreen, and an adhesive. For example, referring to FIG. 10E, liquid silicone and a sunscreen may be dispensed from a dispenser A, and a curing agent may be dispensed from a dispenser B. In cases where the liquid encapsulant layer material 830' includes an adhesive, an encapsulant layer may be bonded to the solar cell 820 even without the primer layer 880. The liquid encapsulant layer material 830' is dispensed to every exposed region of the PCB 810.

Referring to FIG. 11E, the liquid encapsulant layer material 830' may be dispensed to be flat on the solar cell 820 or the primer layer 880. When the liquid encapsulant layer material 830' is dispensed to be flat, a thickness of an encapsulant layer may be formed to be even. If a thickness of the encapsulant layer is not even, the encapsulant layer may partially have low light transmittance. In order for the liquid encapsulant layer material 830' to be dispensed to be flat, the liquid encapsulant layer material 830' is required to have sufficiently spreading characteristics, and thus, in order for the liquid encapsulant layer material 830' to have sufficiently spreading characteristics, the liquid encapsulant layer material 830' may have low viscosity of 10 Pa·s or less.

When the liquid encapsulant layer material 830' has viscosity of 10 Pa·s or less, the liquid encapsulant layer material 830' may flow to an outer side of the PCB 810. However, the dam layer 840 previously formed on the PCB 810 blocks flow of the liquid encapsulant layer material 830'. Thus, flowing of the liquid encapsulant layer material 830' to the outside of the PCB 810 is prevented by the dam layer 840.

FIGS. 11F and 11G are modifications of FIG. 11E. Referring to FIG. 11F, the liquid encapsulant layer material 830" may be dispensed to be thickest in a middle portion thereof and reduced in thickness toward opposing end portions thereof. Here, the middle portion corresponds to a position facing a portion between the second solar cell 822 and the third solar cell 823, and the opposing end portions refer to a left side of the first solar cell 821 and a right side of the fourth solar cell 824. A form in which the encapsulant layer material 830" is dispensed may be varied by adjusting viscosity of the encapsulant layer material 830".

Referring to FIG. 11G, a unit grid of the dam layer 840 is formed at every edge of each of the solar cells 821, 822, 823, and 824, and a encapsulant layer material 830‴ may be disposed to an upper surface of each of the solar cells 821, 822, 823, and 824.

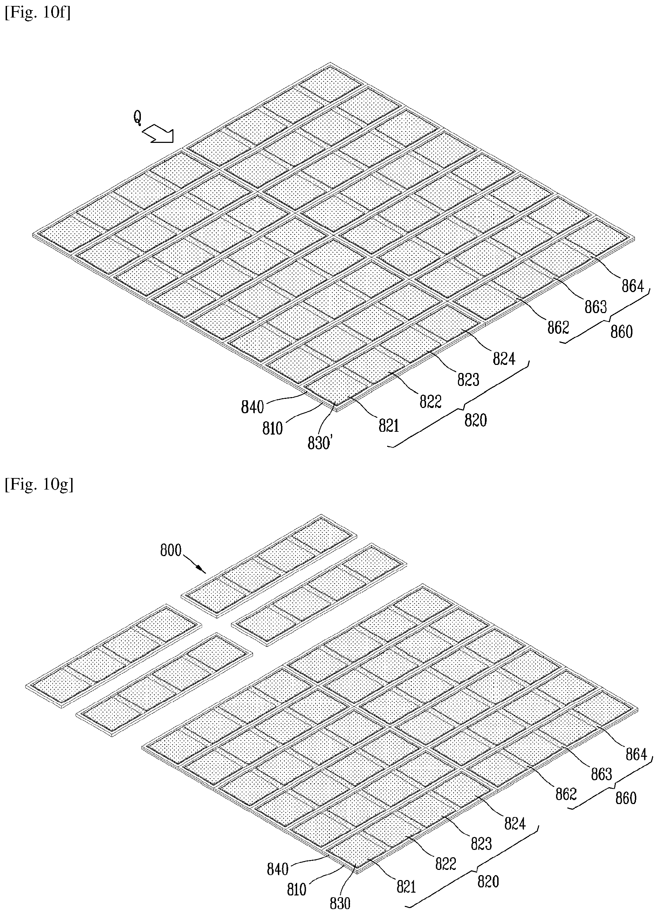

Referring back to FIG. 9, a liquid encapsulant layer material is thermally cured to form an encapsulant layer (S160). FIG. 10F corresponds to step S160.

Referring to FIG. 10F, a process of curing the liquid encapsulant layer material 830' by applying heat Q is illustrated. Conditions for thermal curing the liquid encapsulant layer material 830' may be varied depending on silicone included in the encapsulant layer material 830'. In general, when the encapsulant layer material 830' is thermally treated at 130°C to 150°C for 30 to 150 minutes, the encapsulant layer material 830' is cured to form the encapsulant layer 830 (please refer to FIG. 10F). When the encapsulant layer 830 is formed, a solar cell module assembly is formed.

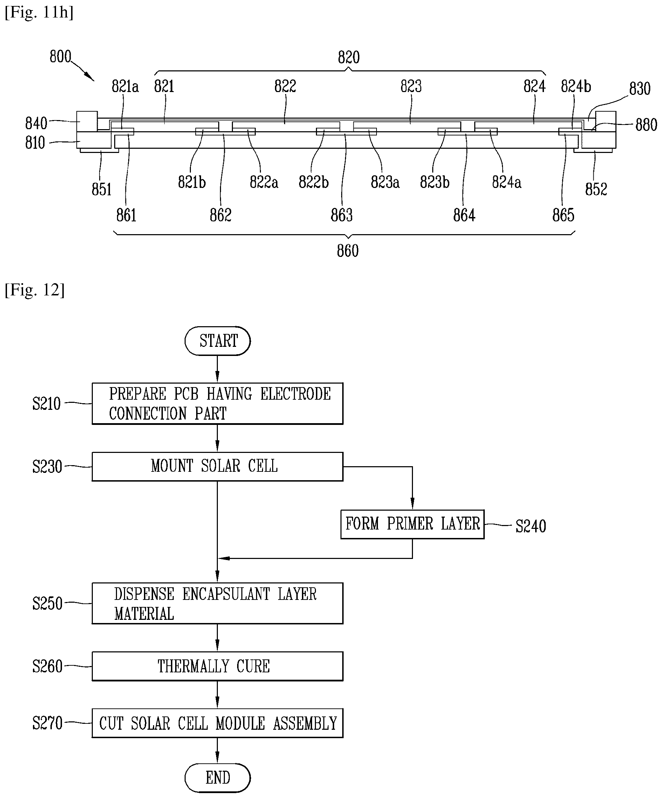

Referring back to FIG. 9, the solar cell module assembly formed by steps S110 to S160 is cut to a unit size of a solar cell module (S170). Since the unit grid has a size corresponding to the solar cell module 100, when the solar cell module assembly is cut along the boundary of the unit grid, the solar cell module assembly may be cut to the unit size of the solar cell module. FIG. 10G illustrates a process of cutting the solar cell module assembly to a unit size of the solar cell module 800. FIG. 11H illustrates the solar cell module 800 cut to the unit size.

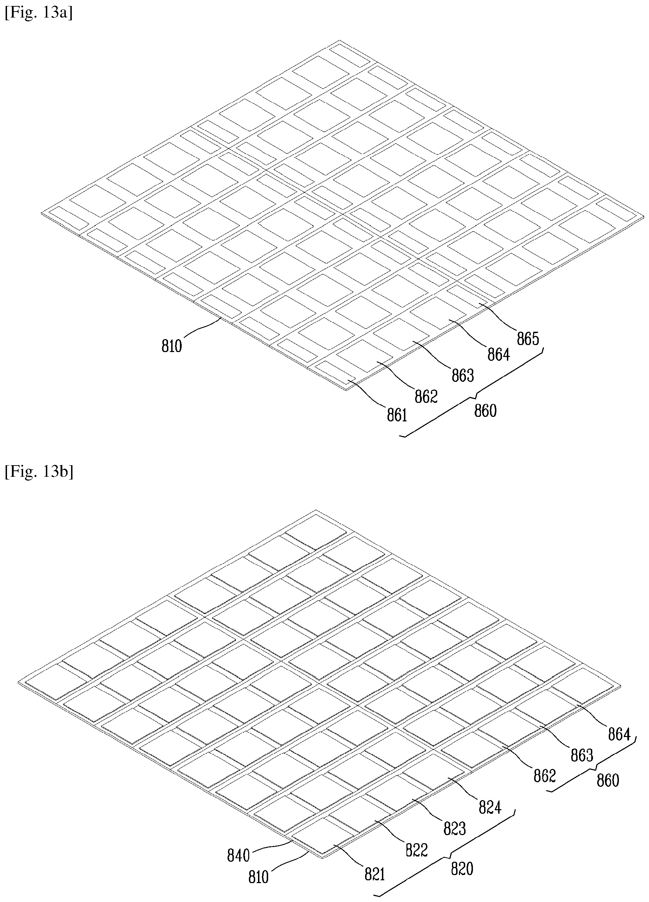

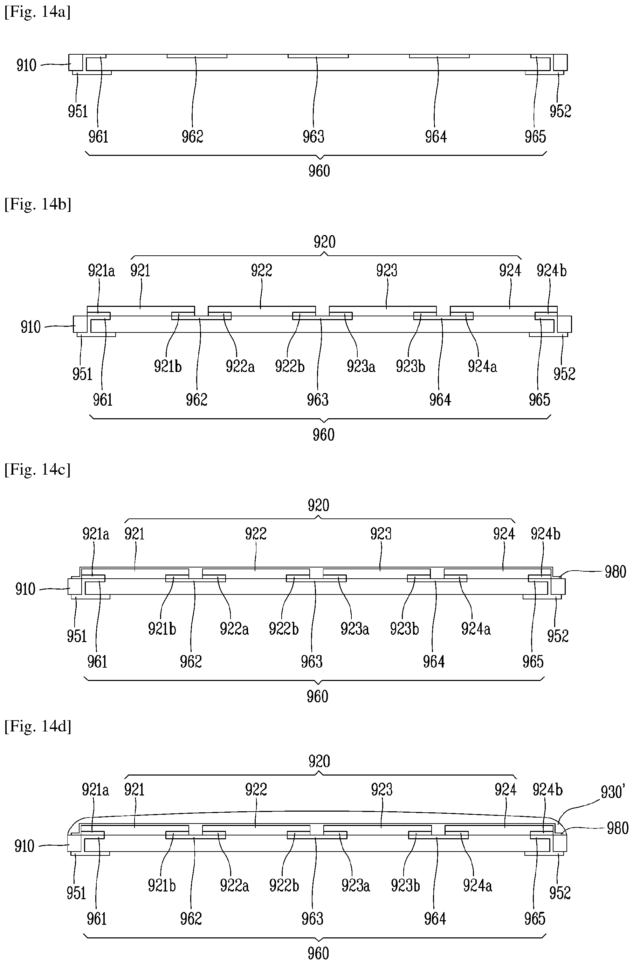

FIG. 12 is a flow chart illustrating a process of manufacturing a solar cell module 500, 600, or 700 (please refer to FIGS. 5 to 7) of the second example. FIGS. 13A to 13E are conceptual views illustrating a process of manufacturing a solar cell module according to the method of manufacturing a solar cell module illustrated in FIG. 12. FIGS. 14A to 14F are cross-sectional views illustrating a process of manufacturing a solar cell module according to the method of manufacturing a solar cell module illustrated in FIG. 12.

FIGS. 13A to 13F illustrate a process of manufacturing a plurality of solar cell modules, and FIGS. 14A to 14F illustrate a process of manufacturing one of a plurality of solar cell modules.

As described above, the solar cell modules 500, 600, and 700 of the second example do not include dam layers 240, 340, and 440 (please refer to FIGS. 2 to 4). Thus, the method for manufacturing the solar cell modules 500, 600, and 700 of the second example is differentiated from the method of manufacturing the solar cell modules 200, 300, and 400 of the first example in that it does not include steps of forming the dam layers 240, 340, and 440. Thus, the above descriptions of the method for manufacturing the solar cell modules 200, 300, and 400 of the first example will be used for the method for manufacturing the solar cell modules 500, 600, and 700 of the second example and redundant descriptions will be omitted.

Referring to FIG. 12, in order to manufacture a solar cell module, first, a PCB 910 having an electrode connection part is prepared (S210). FIGS. 13A and 14A correspond to step S210 of FIG. 12.

Referring to FIG. 13A, the PCB 910 is divided into a plurality of regions, and an electrode connection part 960 is formed in each of the regions. The electrode connection part 960 may have been solder-processed. Wirings other than the electrode connection part 960 may be formed within the PCB 910.

The electrode connection part 960 includes a first electrode connection part 961 to a fifth electrode connection part 965. The first electrode connection part 961 to the fifth electrode connection part 965 are disposed to be spaced apart from each other. The number of the electrode connection parts 961, 962, 963, 964, and 965 may be varied depending on a design of a solar cell module.

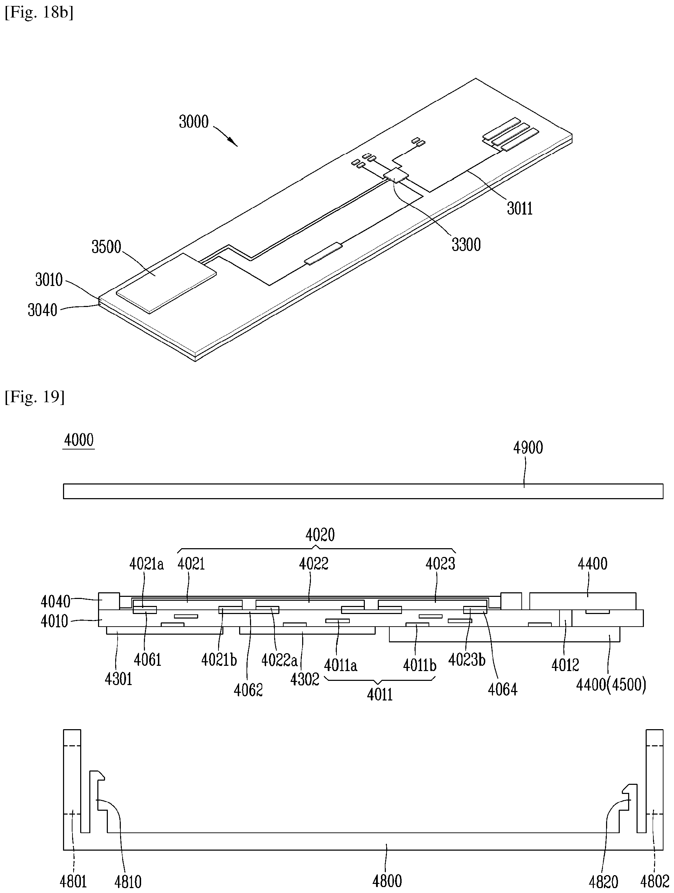

In FIG. 13A, a first surface of the PCB 910 is illustrated, and a second surface of the PCB 910 is illustrated in FIG. 14A. Referring to FIG. 14A, the electrode connection part 960 is exposed to the first surface of the PCB 910, and output terminals 951 and 952 are formed on the second surface of the PCB 910. As illustrated in FIG. 19A, the output terminals 951 and 952 may be formed on one side and the other side of the second surface. Alternatively, the output terminals 951 and 952 may be formed abreast on the second surface, and both the output terminals 951 and 952 may be formed on the first surface or the output terminals 951 and 952 may respectively be formed on the first surface and the second surface.

Referring back to FIG. 12, the PCB is divided into a plurality of regions having a unit size of a solar cell module, and at least one solar cell is mounted in each region (S230). The solar cell is mounted on the first surface of the PCB and the number of solar cells may be varied depending on a design of a solar cell module. FIGS. 13B and 14B correspond to step S230 of FIG. 12.

Referring to FIG. 13B, four solar cells 921, 922, 923, and 924 are respectively mounted in each region of the PCB 910. Referring to FIG. 14D, the solar cells 921, 922, 923, and 924 are disposed to be spaced apart from each other and physically and electrically connected to the electrode connection parts 960 formed on a first surface of the PCB 910. The electrode connection parts 960 are soldered, and thus, when the electrode connection parts 960 are placed on the PCB 910 and heated, the solar cell 920 may be bonded to the electrode connection part 960. However, a method for mounting the solar cell 920 on the PCB 910 is not limited thereto and the solar cell 920 may be mounted using solder paste or soldering.

Referring back to FIG. 12, a primer layer is formed on the solar cell (S240). The primer layer serves to bond an encapsulant layer to the solar cell. FIG. 14C corresponds to step S240 of FIG. 12.

Referring to FIG. 14C, a primer layer 980 is formed on the solar cell 980. In step S240 of forming the primer layer 980, a primer material is disposed on the solar cell 920 and thermally cured. The thermally curing the primer material is performed such that the primer material is heat-treated for 20 to 40 minutes at temperatures 90°C to 110°C.

However, in the solar cell module, the primer layer 980 is not essential, and thus, step S240 of forming a primer layer is not essential in the method of manufacturing a solar cell module. Thus, step S240 of forming a primer layer may be omitted and step S250 of dispensing an encapsulant layer material may be performed immediately after step S230 of mounting a solar cell.

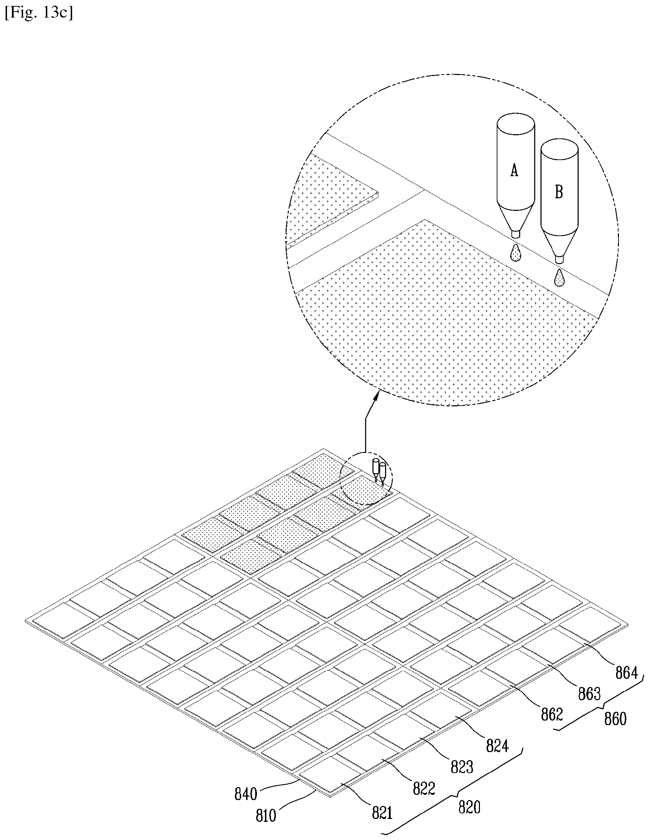

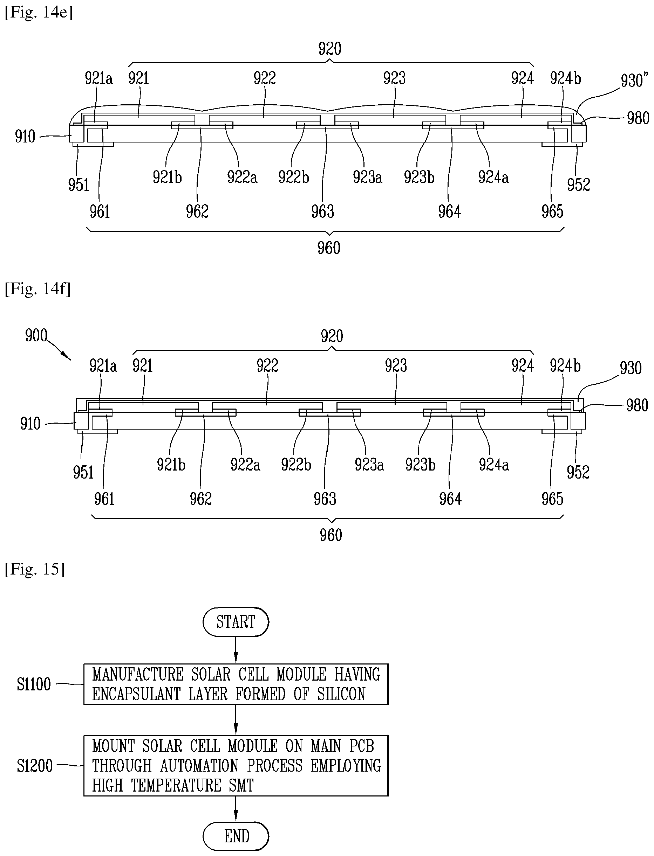

Referring back to FIG. 12, a liquid encapsulant layer material is dispensed (S250) after step S230 of mounting a solar cell or after step S240 of forming a primer layer. Without the primer layer, the encapsulant layer material is dispensed to the solar cell, and with the primer layer, the encapsulant layer material is dispensed to the primer layer. FIGS. 13C, 14D, and 14E correspond to step S250 of FIG. 12.

The liquid encapsulant layer material 930' includes silicone and may additionally include a curing agent, a sunscreen, and an adhesive. Referring to FIG. 13C,

The liquid encapsulant layer material 930' includes silicone and may further include a curing agent, a sunscreen, and an adhesive. Referring to FIG. 13C, liquid silicone and a sunscreen may be dispensed from the dispenser A, and a curing agent may be dispensed from the dispenser B. A boundary of the encapsulant layer material 930' may be formed in every boundary of each region of the PCB 910 or in each of the solar cell 921, 922, 923, and 924.

Referring to FIG. 14D, the liquid encapsulant layer material 930' preferably forms a liquid drop having a contact angle of an acute angle on the solar cell 920 or the primer layer 980. Also, the encapsulant layer material 930' is required to have sufficiently high viscosity, so that the encapsulant layer material 930' is prevented from flowing out of the PCB 910 without a dam layer. To this end, the liquid encapsulant layer material 930' preferably has high viscosity of 40 Pa·s or higher.

Since the encapsulant layer material 930' has sufficiently high viscosity, step S120 (please refer to FIG. 9) of forming a dam layer in the method for manufacturing a solar cell module may be omitted. Accordingly, the number of processes may be reduced, economic efficiency of the manufacturing method may be enhanced, and efficiency of the solar cell module may also be enhanced. Enhancement of efficiency of the solar cell module has been described above.

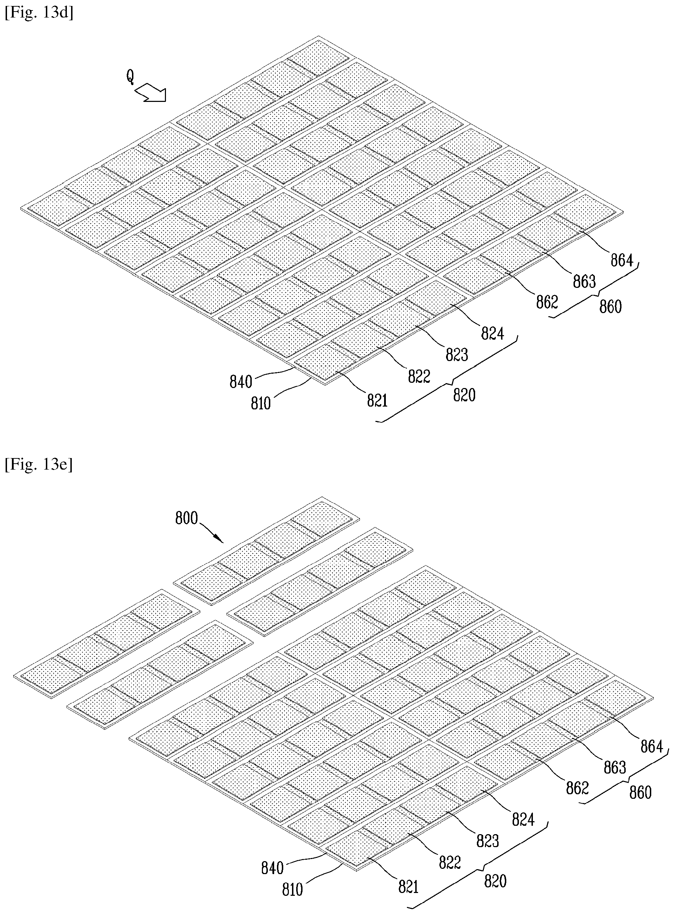

FIG. 14E is a modification of FIG. 14D. Referring to FIG. 14E, a liquid encapsulant layer material 930" may be dispensed to be thickest in a position facing a middle portion of each of the solar cells 921, 922, 923, and 924 and reduced in thickness toward opposing end portions of each of the solar cells 921, 922, 923, and 924. A form of dispensing the encapsulant layer material 930" may be varied by adjusting viscosity of the encapsulant layer material 930". Referring back to FIG. 12, the encapsulant layer material 930" is thermally cured to form an encapsulant layer (S260). FIG. 13D corresponds to step S260 of FIG. 12.

Referring to FIG. 13D, a process of curing the liquid encapsulant layer material 930' by applying heat Q thereto is illustrated. Conditions for thermally curing the liquid encapsulant layer material 930' may be varied depending on silicone included in the encapsulant layer material 930'. In general, when the encapsulant layer material 930' is heat-treated at 130°C to 170°C for 30 to 150 minutes, the encapsulant layer material 930' is cured to form the encapsulant layer 930 (please refer to FIG. 13E). When the encapsulant layer 930 is formed, a solar cell module assembly is formed.

Referring back to FIG. 12, the solar cell module assembly formed by steps S210 to S260 is cut to a unit size of a solar cell module (S270). FIG. 13E illustrates a process of cutting the solar cell module assembly to a unit size of a solar cell module. FIG. 14F illustrates the solar cell module 900 cut to the unit size.

The solar cell modules 100, 200, 300, 400, 500, 600, 700, 800, and 900 described above may be used to supply electric power to an electronic device. Hereinafter, a method for manufacturing an electronic device having a solar cell module will be described.

FIG. 15 is a flow chart illustrating a method of manufacturing an electronic device having a solar cell module.

First, a solar cell module having an encapsulant layer formed of a material including silicone is manufactured (S1100). The method for manufacturing a solar cell module may be referred to the above descriptions related to FIGS. 9 to 14F, and the solar cell modules 100, 200, 300, 400, 500, 600, 700, 800, and 900 manufactured by the method for manufacturing a solar cell module may be referred to the above descriptions related to FIGS. 1 to 8.

Next, the solar cell module is mounted on a main PCB of an electronic device through a surface mount technology (SMT) of mounting a component on a main PCB of an electronic device by applying heat in a furnace (S1200). A temperature of heat applied to the solar cell module through the SMT is about 200°C to 250°C, and the SMT is performed through an automation process.

Automation equipment mounts the solar cell modules 100, 200, 300, 400, 500, 600, 700, 800, and 900 and various element or various circuits on the main PCB, and when heat is applied, while the solar cell modules 100, 200, 300, 400, 500, 600, 700, 800, and 900 and various element or various circuits mounted on the main PCB are passing through the furnace, the solar cell module and various element or various circuits are bonded to the main PCB.

The solar cell module of the present disclosure has an encapsulant layer formed of a material including silicone, and silicone has sufficient heat resistance even at a temperature of a process to which the SMT is applied. Thus, although the solar cell module is mounted on the main PCB through the high temperature SMT, the encapsulant layer is not melted or deformed.

Hereinafter, a sensor module will be described as an embodiment of a solar cell module.

The sensor module described hereinafter includes a solar cell and operates using electric power produced by the solar cell.

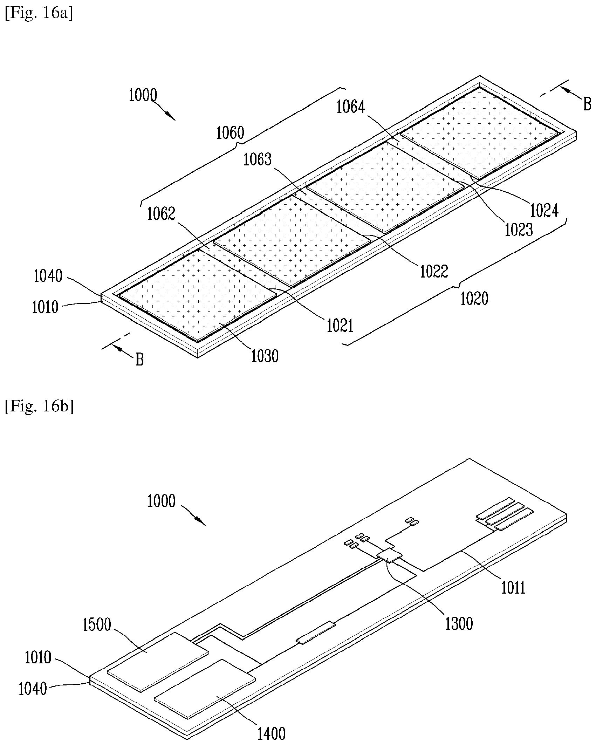

FIGS. 16A and 16B are perspective views of a first embodiment of an integrated sensor module including a solar cell and a circuit component, viewed in different directions.

FIGS. 16A and 16B are perspective views of a first embodiment of an integrated sensor module 1000 including a solar cell and a circuit component, viewed in different directions.

The sensor module 1000 includes a PCB 1010, a solar cell 1020, a circuit component 1300, a sensor part 1400, and a battery 1500.

The PCB 1010 has a first surface and a second surface facing in mutually opposite directions. The first surface is illustrated in FIG. 16A and the second surface is illustrated in FIG. 16B. The first surface may be termed an upper surface or a front surface, and the second surface may be termed a lower surface or a rear surface.

The PCB 1010 has an electrode connection part 1060 on the first surface. Electrode connection parts 1062, 1063, and 1064 are disposed to be spaced apart from each other and connect the solar cells 1021, 1022, 1023, and 1024 mounted on the first surface of the PCB 1010 in series.

The PCB 1010 has a circuit wiring 1011 on the second surface. The circuit wiring 1011 electrically connects electronic components mounted on the PCB 1010, and the electronic components refer to various sensors of the sensor part 1400, the circuit component 1300, and the battery 1500.

The electrode connection part 1060 and the circuit wiring 1011 may be electronically connected by a wiring formed within the PCB 1010. A structure of a through hole or via hole may be formed within the PCB 1010, and a wiring disposed in the through hole or via hole may be connected to the electrode connection part 1060 and the circuit wiring 1011.

The solar cell 1020 is mounted on the first surface of the PCB 1010 and electrically connected to the electrode connection part 1060. In FIG. 16A, a configuration in which four solar cells 1021, 1022, 1023, and 1024 are mounted on the first surface of the PCB 1010 is illustrated. Since the electrode connection part 1060 and the circuit wiring 1011 are electrically connected, the solar cell is electrically connected to the circuit component 1300 and the battery 1500 described hereinafter.

The solar cell 1020 produces electric power required for driving the circuit component 1300 and the sensor part 1400 using light. Since the sensor module 1000 is driven using electric power produced by the solar cell 1020, the sensor module 1000 may be continuously driven even without a separate power cable.

Reference numeral 1030 denotes an encapsulant layer, and 1040 denotes a dam layer. The encapsulant layer and the dam layer are the same as those described above, so description thereof are omitted.

Referring to FIG. 16B, the circuit component 1300 is mounted on the second surface of the PCB 1010 and electrically connected to the circuit wiring 1011. The circuit component 1300 includes various element and various components for driving and controlling the sensor module 1000. For example the circuit component 1300 may include a driving circuit, a charging circuit, a maximum power point tracking (MPPT) algorithm circuit, a DC-to-DC (boost or buck) converter, a communication unit implementing Internet of things of the sensor module 1000, a power source of a sensor part, a battery charging circuit, and the like. Types of the elements and circuits may be changed according to a design of the sensor module 1000.

The sensor part 1400 is an example of an electric element driven by electric power generated by the solar cell. Since the electric element has a solar cell module, the solar cell module may operate as the sensor module 1000. In the present disclosure, types of the electric element are not limited to the sensor part 1400 and various element may be provided according to a design of the solar cell module. This is not limited to the embodiment described herein.

The sensor part 1400 senses a change in a measurement target. The measurement target refers to a physical amount such as a concentration of a material, light or ultrasonic wave, temperature, humidity, and the like, for example.

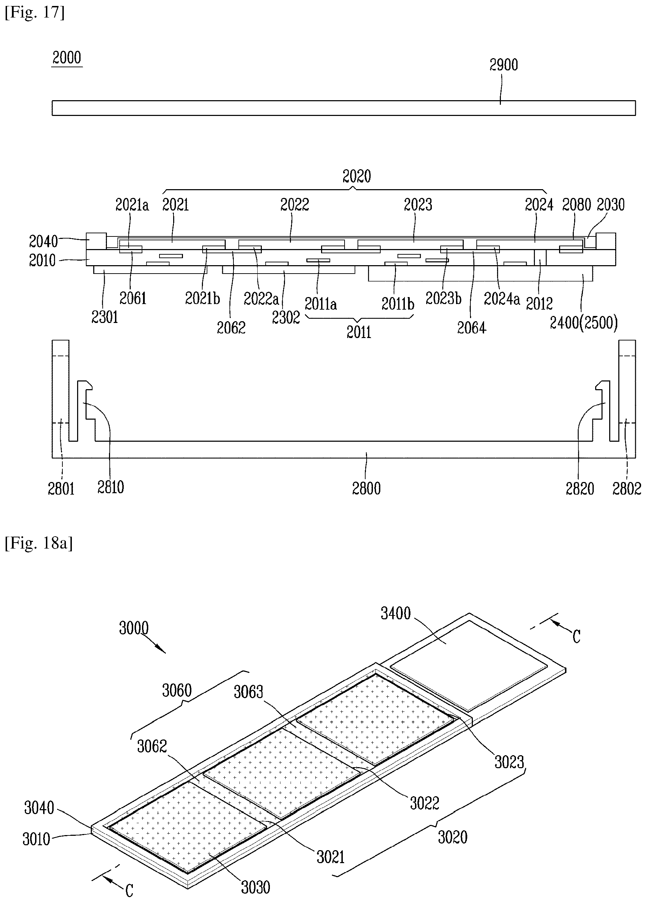

The sensor part 1400 may be mounted on the first surface and/or the second surface. A mounting position of the sensor part 1400 may be varied depending on whether the sensor part 1400 is required to be exposed to light or an external environment. The sensor module 1000 is covered by a case 2800 (please refer to FIG. 17) so as to be protected, and only the first surface is exposed to light to receive light of the solar cell 1020. Thus, the sensor required to be exposed to light or an external environment may be mounted on the first surface together with the solar cell 1020, and any other sensor not required to be exposed may be mounted on the second surface so as to be protected.

For example, a temperature sensor is configured to sense a temperature through contact with air, a humidity sensor is configured to sense humidity through contact with moisture included in the air, and a gas sensor is configured to contact a gas in the air to sense the presence and absence of a gas and a concentration of the gas. Thus, the temperature sensor, the humidity sensor, and the gas sensor is not required to be exposed to light or an external environment. When a vent hole is provided in the case, air may flow through the vent hole so as to be in contact with the temperature sensor, the humidity sensor, and the gas sensor mounted on the second surface.

FIG. 16B illustrates a configuration in which the sensor part 1400 is mounted on the second surface. When the sensor part 1400 includes at least one of the temperature sensor, the humidity sensor, and the gas sensor, the sensor part 1400 is preferably mounted on the second surface to protect the corresponding sensor. Also, when the sensor part 1400 is mounted on the second surface, the first surface may be entirely utilized to dispose the solar cells 1020.

Since the sensor module 1000 includes the battery 1500 coupled to the second surface of the PCB 1010, electric power produced by the solar cell 1020 may be stored in the battery 1050. Light may not exist depending on an environment, and thus, without the battery 1500, the sensor module 1000 may operate only when light is present. However, since the sensor module 1000 includes the battery 1500, electric power produced by the solar cell 1020 when light is present may be stored in the battery 1500 and may be used to drive the sensor module 1000 when light is not present.

In the sensor module 1000 described above, the first surface of the PCB 1010 is used to mount the solar cell 1020 and the second surface is used to mount the circuit component 1300, the sensor part 1400, and the battery 1500.

In particular, the sensor module 1000 of the present disclosure is formed by applying an automation process employing a high temperature SMT. Here, opposing surfaces of the PCB 1010 are utilized to mount components of the sensor module 1000, while applying the automation process based on the high temperature SMT, because the encapsulant layer 1030 has sufficient heat resistance during the automation process using the high temperature SMT.

The sensor module 1000 of the present disclosure has the encapsulant layer 1030 formed of a material including silicone, and the encapsulant layer 1030 has sufficient heat resistance even in a process using the SMT having a high temperature (maximum of about 250°C. Thus, although the circuit component 1300, the sensor part 1400, and the like, are mounted on the second surface through the process using the high temperature SMT in a state in which the solar cell 1020 and the encapsulant layer 1030 are placed on the first surface of the PCB 1010, the encapsulant layer 1030 is not melted or deformed.

Also, in the sensor module 1000 of the present disclosure, since the solar cell 1020 is mounted on the PCB 1010 and the encapsulant layer 1030 is formed without thermo-compression bonding of lamination, it is possible to first form the solar cell 1020 and the encapsulant layer 1030 on the first surface of the PCB 1010 and subsequently mount the circuit component 1300 on the second surface through the SMT.

That is, in the present disclosure, since the encapsulant layer 1030 is not melted or deformed and since mounting of the solar cell 1020 and forming of the encapsulant layer are conducted without thermo-compression bonding, the process of forming the solar cell 1020 and the encapsulant layer 1030 and a high temperature process of mounting the circuit component 1300, and the like, may be freely changed.

In the solar cell module described above with reference to FIGS. 1 to 7, the output terminals are provided on the second surface of the PCB, but the sensor module 1000 described above with reference to FIGS. 16A and 16B do not have output terminals on the second surface of the PCB. The reason is because, the solar cell module described above has a structure formed on the assumption that the solar cell module is mounted on the main PCB, but the sensor module 1000 described herein has a structure in which the output terminals are already connected to the circuit component by the circuit wiring on the PCB. FIGS. 16A and 16B illustrate a structure in which the solar cell 1020 and the circuit component 1300 are formed on different surfaces of the PCB 1010, but both the solar cell 1020 and the circuit component 1300 may be mounted together on the same surface of the PCB 1010.

FIG. 17 is a cross-sectional view of a sensor module 2000 including a case 2800 and a window 2900. The cross-sectional view of FIG. 17 is taken along line B-B of FIG. 16B.

A PCB 2010 has a multi-layer structure. For example, a plurality of insulating layers may be sequentially stacked to form the multi-layer structure of the PCB 2010. Multilayer refers to that circuit wirings 2011 provided in the PCB 2010 form layers and connected three-dimensionally, and the number of layers may be a natural number of 2 or greater.

The circuit wirings 2011 include an inner layer wiring 2011a and an outer layer wiring 2011b. The circuit wiring 2011 illustrated in FIG. 16 is the outer layer wiring 2011b and exposed to the second surface of the PCB 2010. The inner layer wiring 2011a is formed on each layer of the multilayer structure and is electrically connected to electrode connection parts 2061, 2062, and 2064 through a through hole 2012 penetrating through the multilayer structure.

When the PCB 2010 having the multilayer structure is used in the sensor module 2000, high density component mounting and a reduction in a wiring distance may be realized. Thus, the PCB 2010 having a multi-layer structure is appropriate for miniaturization of the sensor module 2000.

A solar cell 2020 mounted on a first surface and a circuit component 2300 mounted on a second surface may be electrically connected by the outer layer wiring 2011b, the inner layer wiring 2011a penetrating through the multilayer structure, and the electrode connection parts 2061, 2062, and 2064.

The case 2800 covers the PCB 2010 to protect the other components of the sensor module 2000. The case 2800 is configured to protect the other part excluding the front surface of the PCB 2010. Vent holes 2801 and 2802 described above are formed on the case 2800.

Coupling parts 2810 and 2820 having a latch structure may be provided on the case 2800. When both ends of the PCB 2010 are inserted into recesses of the coupling parts 2810 and 2820, the PCB 2010 may be fixated to the coupling parts 2810 and 2820.

The coupling parts 2810 and 2820 serves to make the PCB 2010 spaced apart and farther than electronic component such as the circuit components 2301 and 2302 from a bottom surface of the case such that the electronic component such as the circuit components 2301 and 2302 mounted on the second surface of the PCB 2010 are not in contact with the bottom surface of the case 2800. Accordingly, when the PCB 2010 is fixated by the coupling parts 2810 and 2820, electronic component such as the circuit components 2301 and 2302 are not in contact with the bottom surface of the case 2800.

The window 2900 is disposed to face a front side of the solar cell 2020 to protect the solar cell 2020. The window 2900 is formed of a transparent material to allow light to be supplied to the solar cell 2020.

When the PCB 2010 with the solar cell 2020 and the circuit components 2301 and 2302 mounted on opposing surfaces thereof is inserted into a space formed by the case 2800 and the window 2900 is coupled to the case 2800 to protect the front side of the solar cell 2020, the sensor module 2000 of a single product is formed.

In FIG. 17, reference numerals 2021, 2022, 2023, and 2024 denote solar cells, 2021a, 2021b, 2022a, 2023b, and 2024a denote electrode parts of the solar cells (reference numerals of the other electrode parts are omitted), 2030 denotes an encapsulant layer, and 2080 denotes a primer layer. 2400 denotes a sensor part, and 2500 denotes a battery.

FIGS. 18A and 18B are perspective views of a second embodiment of an integrated sensor module including a solar cell and a circuit component, viewed in different directions.

A sensor module 3000 of the second embodiment is different from the first embodiment in that the sensor module 300 includes a sensor part 3400 mounted on a first surface. Thus, the same descriptions as those of the sensor module 2000 of the first embodiment will be omitted.

The sensor module 3000 includes a PCB 3010, a solar cell 3020, a circuit component 3300, a sensor part 3400, and a battery 3500.

The sensor part 3400 may be mounted on a first surface and/or a second surface. A mounting position of the sensor part 3400 may be varied depending on whether it is required to be exposed to light or an external environment as mentioned above.

An infrared sensor is configured to sense the presence or absence of an object or measure a distance to the object using infrared ray. An ultrasonic sensor is configured to sense the presence or absence of an object or measure a distance to the object using ultrasonic waves. An illumination sensor is configured to measure brightness of light. Thus, the infrared sensor, the ultrasonic sensor, and the illumination sensor are required to be exposed to light or an external environment, and if not, the infrared sensor, the ultrasonic sensor, and the illumination sensor may lose the function thereof as sensors.

FIG. 18A illustrates a configuration in which the sensor part 3400 is mounted on a first surface. In cases where the sensor part 3400 includes at least one of the infrared sensor, the ultrasonic sensor, and the illumination sensor, the sensor part 3400 is preferably mounted on the first surface to exhibit the functions of the sensors. Thus, in FIG. 18A, the sensor part 3400 mounted on the first surface may be at least one of the infrared sensor, the ultrasonic sensor, and the illumination sensor.

In FIGS. 18A and 18B, reference numeral 3011 denotes a circuit wiring, 3021, 3022, and 3023 denote solar cells, 3030 denotes an encapsulant layer, 3040 denotes a dam layer, and 3060 denotes an electrode connection part.

FIG. 19 is a cross-sectional view of a case 4800, a window 4900, and a sensor module 3000(4000 in FIG. 19) illustrated in FIGS. 18A and 18B. The cross-sectional view of FIG. 19 is taken along line C-C of FIG. 18B.

A PCB 4010 has a multi-layer structure. For example, a plurality of insulating layers may be sequentially stacked to form the multi-layer structure of the PCB 4010.

In FIG. 19, a configuration in which a solar cell 4020 and a sensor part 4400 are mounted on a first surface of the PCB 4010, and circuit components 4301 and 4302 and a battery 4500 are mounted on the second surface.

Vent holes 4801 and 4802 may be selectively formed on the case 4800. For example, when the sensor part 4400 includes sensors which are required to be exposed to light or an external environment, like an infrared sensor, an ultrasonic sensor, and an illumination sensor, the vent hole 4801 and 4802 may be omitted. However, in cases where the sensor part 4400 includes sensor which are not required to be exposed to light or an external environment, like a temperature sensor, a humidity sensor, and a gas sensor, the vent holes 4801 and 4802 is required to be provided in the case 4800 for operations of the sensors.

A size of a recess provided at a left coupling part 4801 corresponds to the sum of thicknesses of the PCB 4010 and a dam layer 4040, and a size of a recess formed at a right coupling part 4802 corresponds to a thickness of the PCB 4010. This because the dam layer 4040 is not present at a right end portion of the PCB 4010.

In FIG. 19, reference numeral 4011 denotes a circuit wiring, 4011a denotes an inner layer wiring, 4011b denotes an outer layer wiring, 4012 denotes a through hole, 4021, 4022, and 4023 denote solar cells, 4021a, 4021b, 4022a, and 4023b denote electrode parts of the solar cells (reference numerals of the other remaining electrode parts are omitted), 4061, 4062, and 4064 denote electrode connection parts formed on the PCB (reference numerals of the other remaining electrode connection parts are omitted), and 4900 denotes a window.

Hereinafter, a method for manufacturing an electronic device having a solar cell module as an example of a sensor module will be described.

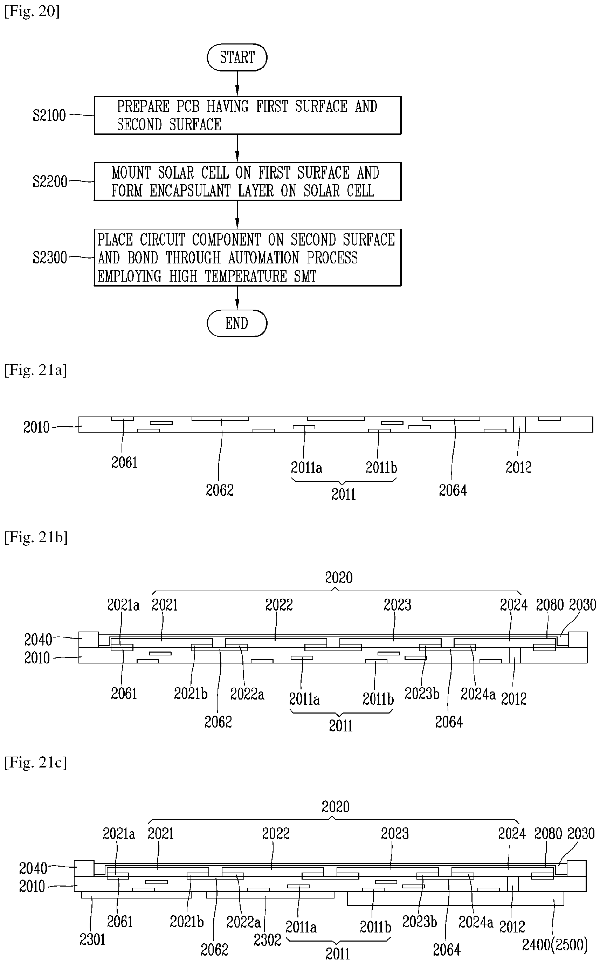

FIG. 20 is a flow chart illustrating a method for manufacturing a sensor module according to the claimed invention.

FIGS. 21A to 21C are cross-sectional views illustrating a process of manufacturing a sensor module according to the method of manufacturing a sensor module illustrated in FIG. 20.

Referring to FIG. 20, first, a PCB having a first surface and a second surface is prepared (S2100). FIG. 21A corresponds to step S2100 of FIG. 20.

Referring to FIG. 21A, a PCB 2010 has a first surface and a second surface facing in the mutually opposite directions. The PCB 2010 may have a multilayer structure. A circuit wiring 2011 of the PCB 2010 is provided in each layer of the multilayer structure, and includes an inner layer wiring 2011a and an outer layer wiring 2011b. The inner layer wiring 2011a and the outer layer wiring 2011b are connected to the electrode connection parts 2061, 2062, and 2064 of the first surface through the through hole 2012 of the multilayer structure.

Referring back to FIG. 20, a solar cell is mounted on the first surface of the PCB and an encapsulant layer is formed on the solar cell (S2200). FIG. 21B corresponds to S2200 of FIG. 20.

Referring to FIG. 21B, the solar cell 2020 is mounted on the first surface of the PCB 2010, and the encapsulant layer 2030 is formed on the solar cell 2020. A method for forming the solar cell 2020 and the encapsulant layer 2030 on the first surface of the PCB 2010 is the same as that described above with reference to FIGS. 9 to 14F. Also, a dam layer 2040 and a primer layer 2080 have also been described above.

Referring back to FIG. 20, a circuit component, or the like, is mounted on the second surface of the PCB and bonded through an automation process employing a high temperature SMT (S2300). FIG. 21C corresponds to step S2300 of FIG. 20.

Referring to FIG. 21C, a configuration in which circuit components 2301 and 2302, a sensor part 2400, and a battery 2500 are mounted on the second surface of the PCB 2010 is illustrated. According to the SMT, a component is mounted on the PCB 2010 by applying heat in a furnace. The SMT is performed through an automation process. Since the encapsulant layer has sufficient heat resistance, it is not melted or deformed during the process employing the SMT.

This may be compared with a solar cell module having an outermost layer including an EVA encapsulant layer and a polymer protective layer. Thus, 1) a case in which a solar cell, an EVA encapsulant layer, and a polymer protective layer (hereinafter, referred to as a "solar cell", etc.) are first stacked on the PCB and a circuit component is subsequently mounted, and 2) a case in which the circuit component is first mounted on the PCB and the solar cell, or the like, is sequentially mounted will be separately described.

In the first case, when the solar cell, or the like, is first mounted on the PCB, the EVA encapsulant layer and the polymer protective layer of the solar cell may be molted or deformed during a subsequent process of mounting a circuit component. The circuit component is mounted on the PCB through the high temperature SMT, and here, the EVA encapsulant layer and the polymer protective layer are melted or deformed at a temperature of the SMT.

In the second case, when the circuit component is first mounted on the PCB, it is difficult to mount a solar cell, or the like. The solar cell, the EVA encapsulant layer, and the polymer protective layer have a multilayer structure, and these form the multilayer structure through a process of lamination. Lamination refers to a process of forming a multilayer structure by compressing the structure on both sides by applying heat, and if a circuit component is mounted on the PCB, the PCB is not flat, making it impossible to perform compression

In FIGS. 21A to 21C, reference numerals 2021, 2022, 2023, and 2024 denote solar cells, and 2021a, 2021b, 2022a, 2023b, and 2024a denote electrode parts of the solar cells (reference numerals of other remaining electrode parts are omitted).

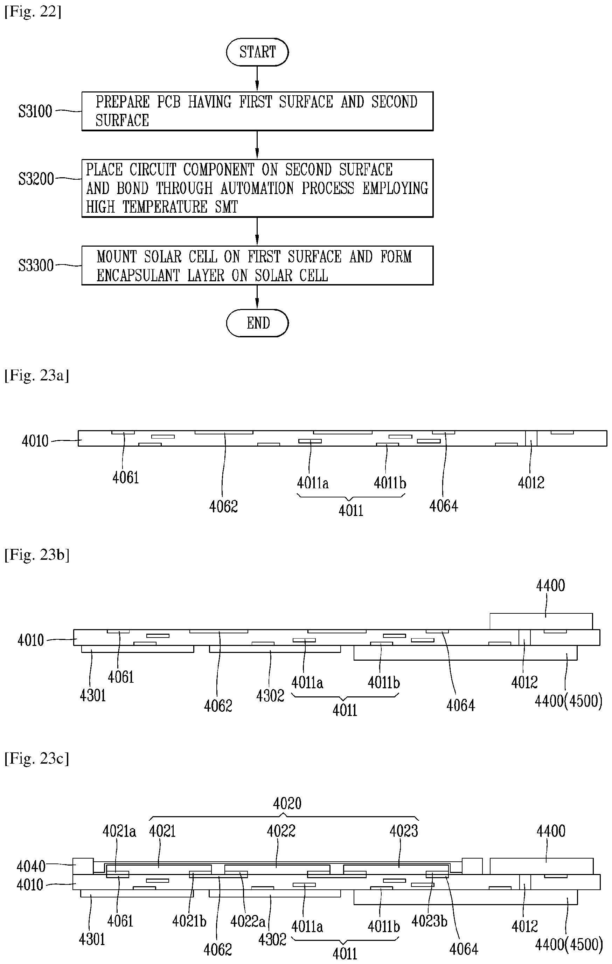

FIG. 22 is a flow chart illustrating another method of manufacturing a sensor module according to the claimed invention.

FIGS. 23A to 23C are cross-sectional views illustrating a process of manufacturing a sensor module according to the method of manufacturing a sensor module illustrated in FIG. 22.

The method of manufacturing a sensor module illustrated in FIG. 22 (S3100, S3200, S3300) is substantially the same as the method of manufacturing a sensor module described above with reference to FIG. 20, except mounting order of a circuit component and a solar cell.

Referring to FIG. 23B, a sensor part 4400 is mounted on a first surface and circuit components 4301 and 4302 and a battery 4500 are mounted on a second surface by performing an automation process employing a high temperature SMT once or continuously (S3200). Thereafter, referring to FIG. 23C, a solar cell 4020 is mounted and an encapsulant layer 4030 is formed (S3300).

Order of mounting the circuit component 4300 and the solar cell 4020 on the PCB 4010 may be interchanged, and, in the present disclosure, although the SMT is applied, the encapsulant layer 4030 is not melted or deformed.

In FIGS. 23A to 23C, reference numeral 4011 denotes a circuit wiring, 4011a denotes an inner layer wiring, 4011b denotes an outer layer wiring, 4012 denotes a through hole, 4021, 4022, and 4023 denote solar cells, 4021a, 4021b, 4022a, and 4023b denote electrode parts of the solar cells (reference numerals of other remaining electrode parts are omitted), 4040 denotes a dam layer, and 4061, 4062, and 4064 denote electrode connection parts (reference numerals of other remaining electrode connection parts are omitted).

According to the present disclosure having the configuration described above, since the solar cell module includes the encapsulant layer formed of a material including silicone, the solar cell module has sufficient heat resistance even during the process employing the SMT. Thus, although the solar cell module is mounted on the PCB through the process of employing the high temperature SMT together with the circuit component, the encapsulant layer is prevented from being melted or deformed.

Also, since the encapsulant layer has light transmittance higher than that of the multilayer structure of the polymer protective layer and the EVA encapsulant layer in every light wavelength region, an amount of light incident to the solar cell may be enhanced and efficiency of the solar cell may be improved.

Also, since the present disclosure provides the method of forming the encapsulant layer 1) using an encapsulant layer material having low viscosity with respect to a dam layer or 2) using an encapsulant layer material having high viscosity without a dam layer, the solar cell module applicable to the high temperature SMT is manufactured using the method. Also, the solar cell module manufactured thusly may be mounted on a main PCB of an electronic device such as a sensor module through the SMT without a problem of melting or deformation.

Also, when an encapsulant layer is formed of a material including silicone, a base for utilizing both surfaces of the PCB to mount the solar cell and the circuit component, respectively, is prepared. Accordingly, the solar cell, or the like, is mounted on the first surface of the PCB and the circuit component may be mounted on the second surface to form an integrated sensor module.

This effect may not be anticipated in a solar cell module having a polymer protective layer and an EVA encapsulant layer and is an advantageous effect obtained as the polymer protective layer and the EVA encapsulant layer are replaced with the silicone encapsulant layer of the present disclosure.

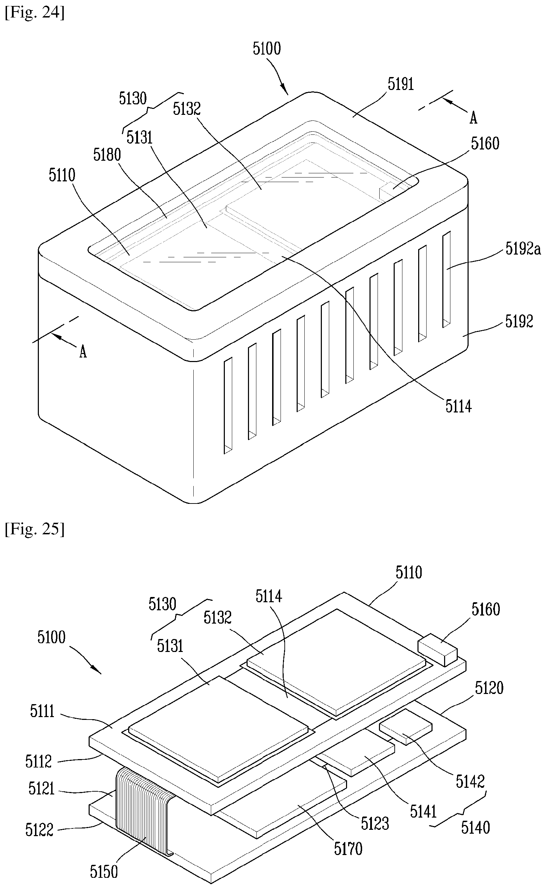

FIG. 24 is a perspective view illustrating a solar cell module 5100 of the present disclosure, said solar cell module 5100 not being part of the claimed invention..

The solar cell module 5100 refers to a module having a solar cell 5130 to produce electric power from light. A module refers to a constituent unit of a machine or a system and represents an independent unit formed by assembling several electronic components or mechanical components to have a specific function. Thus, the solar cell module may be understood as indicating an independent unit having a solar cell and having a function of producing electric power from light. In particular, the solar cell module 5100 may be utilized for the purpose of a sensor.

The solar cell module 5100 includes cases 5191 and 5192, a window 5180, and components accommodated within the cases 5191 and 5192.

The cases 5191 and 5192 are configured to accommodate the other remaining components of the solar cell module 5100 therein. The cases 5191 and 5192 are configured to protect regions other than a front side of the solar cell module 5100. Referring to FIG. 24, the window 5180 is formed on a front side of the solar cell module 5100, and the other remaining regions excluding the window 5180 are all protected by the cases 5191 and 5192.

Components accommodated within the cases 5191 and 5192 include a first PCB 5110, a solar cell 5130, and a sensor part 5160 illustrated in FIG. 24, but not limited thereto. Any component required to be protected by the cases 5191 and 5192 may be accommodated within the cases 5191 and 5192.

The cases 5191 and 5192 may include a first case 5191 and a second case 5192 which can be coupled to each other.

The first case 5191 may be configured to surround the circumference of the window 5180. The first case 5191 may be formed of an opaque material and may be provided in a region not visually blocking the solar cell 5130. Edges of the first case 5191 may be configured to be coupled to the second case 5192.

The second case 5192 may form a side wall and a bottom of the solar cell module 5100. The second case 5192 may be configured to accommodate the other remaining components of the solar cell module 5100. A vent hole 5192a may be provided in the second case 5192. The vent hole 5192a serves for sensors not required to be exposed to light or an external environment. The vent hole 5192a will be described later.

When the internal components of the solar cell module 5100 are required to be maintained and repaired, the first case 5191 and the second case 5192 may be separated from each other to expose the internal components.

The window 5180 is coupled to the cases 5191 and 5192 to cover the solar cell 5130 accommodated within the cases 5191 and 5192. For example, a circumference of the window 5180 may be coupled to the first case 5191. The window 5180 is disposed to face a front side of the solar cell 5130 to protect the solar cell 5130. The window 5180 is formed of a transparent material to allow light to be provided to the solar cell 5130.

The other remaining components of the solar cell module 5100 are accommodated within a spaced formed by the window 5180 and the cases 5191 and 5192. In FIG. 24, a configuration in which the first PCB 5110, the solar cell 5130, and the sensor part 5160 are accommodated within the cases 5191 and 5192 is illustrated.

The solar cell 5130 is mounted on the first PCB 5110 and is disposed to be visually exposed through the window 5180. The reason why the solar cell 5130 is disposed to be visually exposed through the window 5130 is to allow the solar cell 5130 to receive light.

The number of solar cells 5130 mounted on the first PCB 5110 may be determined according to a design of the solar cell module 5100. In FIG. 24, a configuration in which two solar cells 5131 and 5132 are mounted on the first PCB 5110 is illustrated.

Similar to the solar cell 5130, the sensor part 5160 may also be installed on the first PCB 5110 and disposed to be visually exposed through the window 5180. The sensor part 5160 may be required to be exposed to light or an external environment depending on a type of a sensor provided in the sensor unit 5160, and FIG. 24 illustrates such a configuration.

For example, the infrared sensor is configured to sense the presence or absence of an object or measure a distance to the object using infrared ray. An ultrasonic sensor is configured to sense the presence or absence of an object or measure a distance to the object using ultrasonic waves. An illumination sensor is configured to measure brightness of light. Thus, the infrared sensor, the ultrasonic sensor, and the illumination sensor are required to be exposed to light or an external environment, and if not, the infrared sensor, the ultrasonic sensor, and the illumination sensor may lose the function thereof as sensors.

Thus, the sensor part 5160 illustrated in FIG. 24 includes at least one of the infrared sensor, the ultrasonic sensor, and the illumination sensor. Went the sensor part 5160 includes only sensors required to be exposed to light or an external environment such as the infrared sensor, the ultrasonic sensor, and the illumination sensor, the aforementioned vent hole 5192a may be optional, because the vent hole 5192a serves for sensors not required to be exposed to light or an external environment.

Hereinafter, internal components of the solar cell module 5100 which is simplified and has a reduced size, compared with the related art will be described.

FIG. 25, which is not part of the claimed invention, is a perspective view illustrating components accommodated within the cases 5191 and 5192.

The solar cell module 5100 includes the first PCB 5110, a second PCB 5120, the solar cell 5130, an electric element 5140, and the sensor part 5160.

The first PCB 5110 has a first surface 5111 and a second surface 5112 facing in the mutually opposite directions. The first surface 5111 may be referred to as an upper surface or a front surface, and the second surface 5112 may be referred to as a lower surface or a rear surface. The surface exposed through the window 5180 described above with reference to FIG. 24 is the first surface 5111.

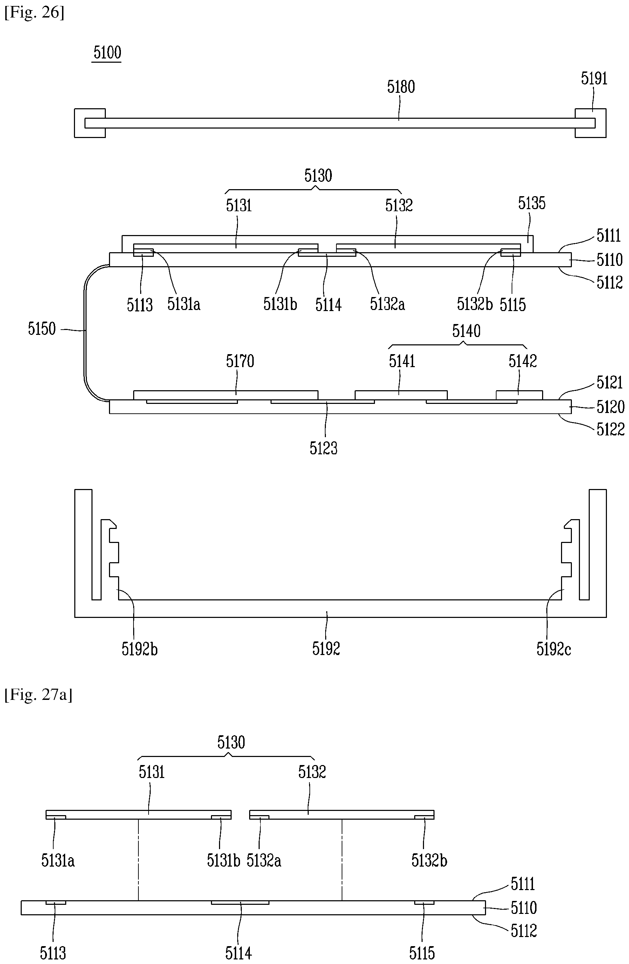

An electrode connection part 5114 is provided on the first PCB 5110. The electrode connection part 5114 is exposed to the first surface 5111 and electrically connected to solar cell 5130 mounted on the first surface 5111. However, some (5113 and 5115) (please refer to FIG. 26) of the electrode connection parts of FIG. 25 are covered by the solar cell 5130 mounted thereon.

The second PCB 5120 is disposed to be spaced apart from the first PCB 5110 and face the second surface 5112 of the first PCB 5110. In relation to FIG. 25, the seconds PCB 5120 is disposed below the first PCB 5110. Within the cases 5191 and 5192 described above with reference to FIG. 24, the first PCB 5110 and the second PCB 5120 are disposed at different levels to form a multi-stage structure.

Like the first PCB 5110, the second PCB 5120 has a first surface 5121 and a second surface 5122 facing in mutually opposite directions. The first surface 5111 may be referred to as an upper surface or a front surface and the second surface 5112 may be referred to as a lower surface or a rear surface.

A circuit wiring 5123 is formed on the second PCB 5120. The circuit wiring 5123 is electrically connected to an electric element 5140 mounted on the second PCB 5120 and electrically connects various elements and various circuits 5141 and 5142 belonging to the electric element 5140.

The solar cell 5130 is mounted on the first surface 5111 of the first PCB 5110. Since the first surface 5111 of the first PCB 5110 is disposed to face the window 5180 described above with reference to FIG. 24, the solar cell 5130 mounted on the first surface 5111 may be visually exposed through the window 5180.

As the solar cell 5130 is visually exposed through the window 5180, light may be incident to the solar cell 5130 through the transparent window 5180. The solar cell 5130 is configured to produce electric power required for driving the solar cell module 5100 using the light.

The electric element 5140 is mounted on the first PCB or the second PCB 5120. The electric element 5140 is driven with electric power produced by the solar cell 5130. Since the electrode connection part 5114 and the circuit wiring 5123 are electrically connected by a connection part 5150 as described hereinafter, electric power produced by the solar cell 5130 may be used for driving the electric element 5140.

The electronic element 5140 includes various elements and various circuits 5141 and 5142 for driving and controlling the solar cell module 5100. The electric element 5140 includes various element and various components for driving and controlling the sensor module 1000. For example the electric element 5140 may include a driving circuit, a charging circuit, a maximum power point tracking (MPPT) algorithm circuit, a DC-to-DC (boost or buck) converter, a communication unit implementing Internet of things of the solar cell module 5100, a power source of the sensor part 5160, a battery charging circuit, and the like. In FIG. 24, a configuration in which two elements 5141 and 5142 are mounted on the second PCB 5120 is illustrated, but types of the elements and circuits may be changed according to a design of the solar cell module 5100.

The battery 5170 may be installed in the first PCB 5110 or the second PCB 5120. The battery 5170 stores electric power produced by the solar cell 5130. Electric power produced by the solar cell 5130 may be converted into electric power which can be stored in the battery 5170 by a power conversion circuit and subsequently stored in the battery 5170.

Also, the electric power stored in the battery 5170 may be used for driving the solar cell module 5100, and in particular, when light is not present, the solar cell module 5100 may be driven using electric power stored in the battery 5170.

The connection part 5150 is connected to the first PCB 5110 and the second PCB 5120. The connection part 5150 is configured to electrically connect the electrode connection part 5114 provided in the first PCB 5110 and the circuit wiring 5123 provided in the second PCB 5120. Since the electrode connection part 5114 of the first PCB 5110 is electrically connected to the solar cell 5130 and the circuit wiring 5123 of the second PCB 5120 is electrically connected to the electric element 5140, the solar cell 5130 and the electric element 5140 are resultantly electrically connected to each other by the connection part 5150.

In FIG. 25, a configuration in which the connection part 5150 is formed by a flexible printed circuit (FPC) is illustrated. The FPC refers to a wiring unit forming a precise chemical fine circuit between a polyimide base having insulating properties and heat resistance and a cover lay to have flexibility and bendability.

In general, a PCB is formed as an insulator such as phenol or an epoxy and thus, the PCB is not flexible and bendable. In contrast, the FPC is flexible and bendable, and thus, a difference in level between the first PCB 5110 and the second PCB 5120 may be freely set. Accordingly, a structure of coupling parts 5192b and 5192c (please refer to FIG. 26) described hereinafter may be freely changed.

Since the solar cell 5130 mounted on the first PCB 5110 and the electric element 5140 mounted on the second PCB 5120 are electrically connected by the connection part 5150, electric power produced by the solar cell 5130 may be controlled by the electric element 5140. Thus, the solar cell 5130 and the electric element 5140 may be mounted on different PCBs.

In order to produce sufficient electric power, a larger number of the solar cells 5130 may be provided, and in order to receive light, a plurality of solar cells 5130 are required to be disposed on one surface (surface on which light is directly shed) of the PCB. In addition, in order to drive the solar cell module 5100, the electric element 5140 is required to be mounted on the PCB. In the related art, since a solar cell and an electric element are mounted on the same PCB, the single PCB should be divided into a region for mounting the solar cell and a region for mounting the electric element. In the related art structure, in order to increase the number of solar cells, an area of a solar cell module is inevitably increased.

In contrast, according to the structure of the present disclosure, the first surface of the first PCB may entirely be utilized for mounting the solar cell 5130. The first surface 5111 of the first PCB 5110 may not need to be divided into a mounting region of the solar cell 5130 and a mounting region of the electric element 5140. The sensor part 5160 may be inevitably mounted on the first surface 5111 of the first PCB 5110, but it may also be possible for the sensor part 5160 to be mounted on the second PCB 5120 depending on a type of a sensor belonging to the sensor part 5160.

Instead, the second PCB 5120 is utilized as a mounting region of the electric element 5140. In addition, since the second PCB 5120 is disposed at a level different from that of the first PCB 5110 to overlap the first PCB 5110, rather than being disposed to be coplanar with the first PCB 5110, an area occupied by the solar cell module 5100 may be reduced, relative to the related art.

Also, since the structure of the present disclosure does not require a complicated cable connection between components, the structure of the solar cell module 5100 may be simplified. In particular, the structure in which components are connected by a cable causes a difficulty of maintenance, and thus, the structure of the present disclosure facilitates maintenance of the solar cell module 5100.

Also, when the area occupied by the solar cell module 5100 is reduced, limitations in an installation place of the solar cell module 5100 may be mostly resolved. The solar cell module 5100 having the solar cell 5130 is limited in direction because it is required to be disposed to face a light incident direction to receive light and limited in size because it should be installed in a narrow space according to circumstances. However, when the area occupied by the solar cell module 5100 is reduced by the structure of the present disclosure, the limitation in size may be resolved, and thus, the limitation in an installation place may also be resolved.

FIG. 26, which is not part of the claimed invention, is a cross-sectional view of the solar cell module 5100.

Electrode connection parts 5113, 5114, and 5115 are formed on a first surface 5111 of the first PCB 5110. The solar cells 5131 and 5132 have two electrodes 5131a and 5131b and 5132a and 5153b, respectively, and the electrodes 5131a and 5131b and 5132a and 5132b are electrically connected to the electrode connection parts 5113, 5114, and 5115. Accordingly, the solar cells 5131 and 5132 are connected in series.

The encapsulant layer and/or the protective layer 5135 are configured to cover the solar cell. The encapsulant layer and/or the protective layer 5135 may be formed of various materials. For example, the polymer protective layer may be bonded to the solar cell by an EVA encapsulant layer or a PC (polycarbonate) encapsulant layer. Also, in this case, the polymer protective layer corresponds to an outermost layer protecting the solar cell.

In another example, the encapsulant layer may be formed of a material including silicone. Silicone advantageously has high heat resistance, relative to an EVA encapsulant layer. Since silicone may form an outermost layer of the solar cell module, a separate protective layer is not required.

A circuit wiring 5123 is formed on the second PCB 5120, and the circuit wiring 5123 may be exposed to the first surface 5121 of the second PCB 5120. The electric element 5140 and the battery 5170 is mounted on the first surface 5121 of the second PCB 5120 and electrically connected to the circuit wiring 5123.

In FIG. 26, a component is not mounted on the second surface 5112 of the first PCB 5110 and the second surface 5122 of the second PCB 5120, but, if necessary, a component may be mounted on the second surfaces 5112 and 5122. Components mounted on the second surfaces 5112 and 5122 may be electrically connected by the connection part 5150, and this structure will be described later.

Coupling parts 5192b and 5192c may be provided on the cases 5192. Referring to FIG. 26, the coupling parts 5192b and 5192c protrude from a bottom of the second case 5192. The coupling parts 5192b and 5192c are provided to fixate the first PCB 5110 and the second PCB 5120 at different levels. For example, as illustrated in FIG. 26, latch type recesses may be provided on the coupling parts 5192b and 5192c. Two recesses forming a difference in level are formed at each of the coupling parts 5192b and 5192c, and the first PCB 5110 and the second PCB 5120 are inserted into the recesses.

The first PCB 5110 and the second PCB 5120 may be fixated to different levels by the coupling parts 5192b and 5192c and may face each other. In the present disclosure, a structure for fixating the first PCB 5110 and the second PCB 5120 is not limited and any structure may be used as long as it can fixate the first PCB 5110 and the second PCB 5120 are fixated at different levels.

In FIG. 26, reference numeral 5180 denotes a window, and the window 5180 is the same as that described above.

FIGS. 27A to 27C are conceptual views illustrating an example of a method for manufacturing a solar cell module, said method not being part of the claimed invention.

First, referring to FIG. 27A, the electrode connection parts 5113, 5114, and 5115 are formed on the first PCB 5110, and the solar cell 5130 is mounted on the first PCB 5110 and electrically connected to the electrode connection parts 5113, 5114, and 5115. The solar cell 5130 may be mounted in various manners. For example, the solar cell 5130 may be bonded to the electrode connection parts 5113, 5114, and 5115 using solder.

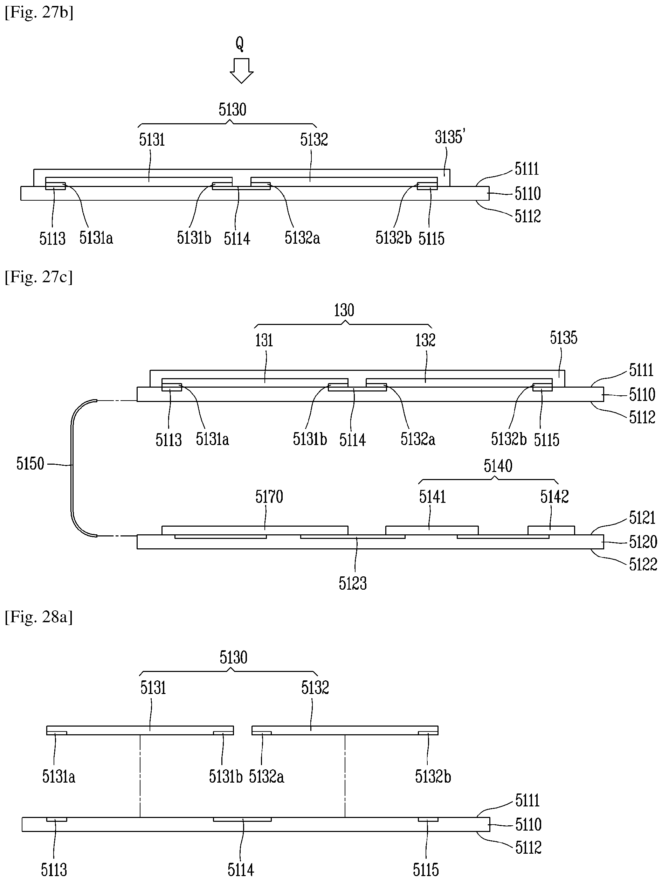

Next, referring to FIG. 27B, a liquid encapsulant layer material 5135' is dispensed to the solar cell 5130 and heat is applied thereto to form an encapsulant layer 5135. The encapsulant layer 5135 may be an outermost layer covering the solar cell 5130 as necessary. For example, in cases where the encapsulant layer 5135 is formed of a material including silicone, the encapsulant layer 5135 may not require a separate protective layer.

The silicone encapsulant layer is formed by dispensing a liquid encapsulant layer material 5135' to the solar cell and applying heat Q to thermally cure the liquid encapsulant layer material 5135'. If the liquid encapsulant layer material 5135' does not include an adhesive, a primer layer providing adhesive strength may be formed between the solar cell 5130 and the encapsulant layer 5135.

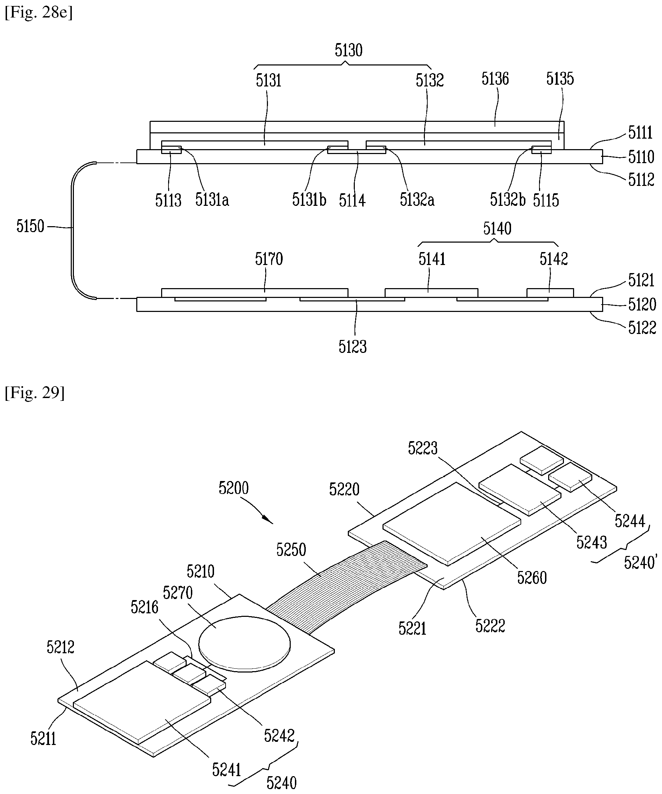

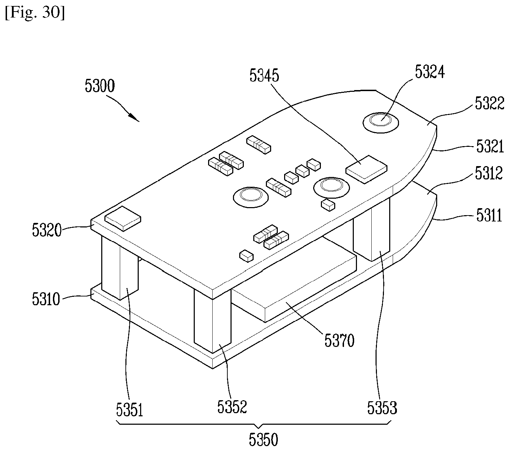

At least some of electric elements, in addition to the solar cell 5130, may be mounted on the first PCB 5110, and types and number of electric elements may be varied depending on a design. An electric element mounted on the first PCB 5110 may be mounted on the first surface 5111 or the second surface 5112 of the first PCB 5110. A configuration in which an electric element is mounted on the first PCB 5110 is illustrated in FIGS. 29 and 30.

In particular, since the silicone encapsulant layer 5135 has high heat resistance as mentioned above, in cases where an electric element is intended to be mounted on the first PCB 5135, an automation process employing a high temperature SMT may be used. The automation process employing the high temperature SMT refers to a process of bonding a PCB and an electric element by applying heat in a furnace. Forming the silicone encapsulant layer 5135 on the first PCB 5110 and mounting an electric element may be interchanged in order.

Thereafter, as illustrated in FIG. 27C, a circuit wiring 5123 is formed on the second PCB 5120, and an electric element 5140 is mounted on the second PCB 5120 and electrically connected to the circuit wiring 5123. Finally, when the first PCB 5110 and the second PCB 5120 are connected by the connection part 5150, the solar cell 5130, or the like, mounted on the first PCB 5110 and the electric element 5140, or the like, mounted on the second PCB are electrically connected. In FIG. 27C, reference numeral 5170 is a battery.

FIGS. 28A to 28E are conceptual views illustrating another example of a method for manufacturing a solar cell module, said method not being part of the claimed invention.

First, referring to FIG. 28A, the electrode connection parts 5113, 5114, and 5115 are formed on the first PCB 5110, and the solar cell 5130 is mounted on the first PCB 5110 and electrically connected to the electrode connection parts 5113, 5114, and 5115.

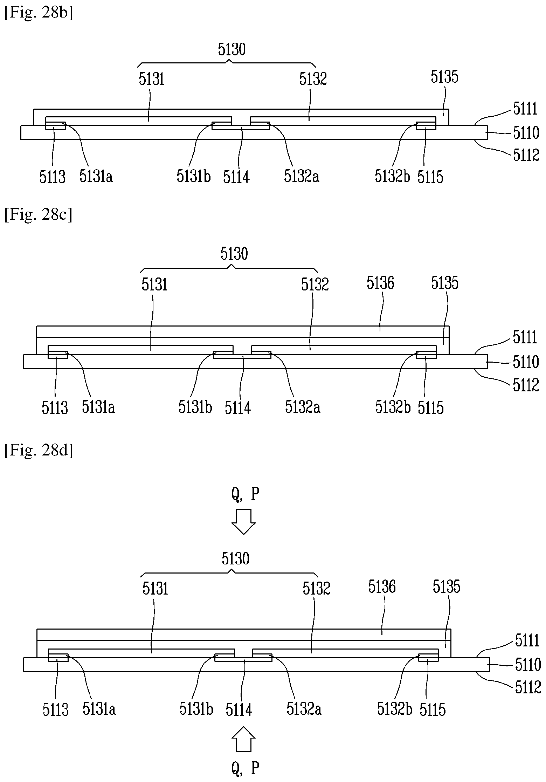

Next, referring to FIG. 28B, the encapsulant layer 5135 is stacked on the solar cell 5130. Also, referring to FIG. 28C, a protective layer 5136 is stacked on the encapsulant layer 5135. Thereafter, referring to FIG. 28D, the first PCB 5110, the solar cell 5130, the encapsulant layer 5135, and the protective layer 5135 are compressed (P) from both side, while applying heat Q thereto, during a lamination process, to bond the protective layer 5136 to the solar cell 5130.

The encapsulant layer 5135 may be formed of EVA or PC as described above, and the protective layer 5136 may be formed of a polymer. During the lamination process, as the encapsulant layer 5135 are melted and thermally cured, the protective layer 5136 is bonded to the solar cell 5130.

As described above, at least some of electric elements, in addition to the solar cell 5130, may be mounted on the first PCB 5110, and types and number of the electric elements mounted on the first PCB 5110 may be varied depending on a design. An electric element mounted on the first PCB 5110 may be mounted on the first surface 5111 of the second surface 5112 of the first PCB 5110. A configuration in which an electric element is mounted on the first PCB 5110 is illustrated in FIGS. 29 and 30.

Next, referring to FIG. 28E, a circuit wiring 5123 is formed on the second PCB 5120, and the electric element 5140 is mounted on the second PCB 5120 and electrically connected to the circuit wiring 5123. Finally, when the first PCB 5110 and the second PCB 5120 are connected by the connection part 5150, the solar cell 5130, or the like, mounted on the first PCB 5110 and the electric element 5140, or the like, mounted on the second PCB 5120 are electrically connected to each other.

Hereinafter, other embodiments of the solar cell module will be described and a redundant description will be omitted.

FIG. 29 is a perspective view illustrating another embodiment of a solar cell module 5200.

In FIG. 29, a second surface 5212 of a first PCB 5210 and a first surface 5221 of a second PCB 5220 are illustrated. A solar cell is mounted on the first surface 5211 of the first PCB 5210.

A circuit wiring 5216 is formed on the second surface 5212 of the first PCB 5210, and an electric element 5240 and a battery 5270 are mounted on the second surface 5212 and electrically connected to the circuit wiring 5216. The electric element 5240 has a concept of including various elements and various circuits 5241 and 5242, and thus, at least one of the electric elements 5240 mounted on the second surface 5212 may be a power conversion circuit. Electric power produced by the solar cell is converted to be appropriately stored in a battery 5270 by the power conversion circuit and subsequently stored in the battery 5270.

A sensor part 5260 is mounted on the first surface 5221 or the second surface 5222 of the second PCB 5220. A mounting position of the sensor part 5260 may be varied depending on whether the sensor part 5260 is required to be exposed to light or an external environment as described above.

A temperature sensor is configured to sense a temperature through contact with air, a humidity sensor is configured to sense humidity through contact with moisture included in the air, and a gas sensor is configured to contact a gas in the air to sense the presence and absence of a gas and a concentration of the gas. Thus, the temperature sensor, the humidity sensor, and the gas sensor is not required to be exposed to light or an external environment. When the vent hole 5192a (please refer to FIG. 24) is provided in the case 5191 or 5192 (please refer to FIG. 24), air may flow through the vent hole 5192a so as to be in contact with the temperature sensor, the humidity sensor, and the gas sensor mounted on the second PCB 5220.

When the sensor part 5260 includes at least one of the temperature sensor, the humidity sensor, and the gas sensor, the sensor part 5260 is preferably mounted on the second PCB 5220 to protect the corresponding sensor. Also, when the sensor part 5260 is mounted on the second PCB 5220, the first surface 5211 of the first PCB 5210 may be entirely utilized to dispose the solar cells.

A communication unit realizing Internet of things may be mounted on the first PCB or the second PCB. If a multi-stage structure of the solar cell module interferes with signal transmission and reception of the communication unit, the communication unit is preferably mounted on the first PCB. The reason is because, when the communication unit is mounted on the first PCB, a factor interfering with signal transmission and reception may be eliminated.

In FIG. 29, reference numeral 5223 denotes a circuit wiring, 5240' denotes an electric element mounted on the second PCB 5220, 5243 and 5244 denote various elements and various circuits, and 5250 denotes a connection part.

FIG. 30 is a perspective view illustrating another example of a solar cell module 5300, said solar cell module 5300 not being part of the claimed invention.

In FIG. 30, a second surface 5312 of a first PCB 5310 and a second surface 5322 of a second PCB 5320 are illustrated. A solar cell is mounted on the first surface 5311 of the first PCB 5310. An electric element 5345 is mounted on the second surface 5312 of the second PCB 5320.

The connection part 5350 may be formed by connectors 5351, 5352, and 5353, and the first PCB 5310 and the second PCB 5320 are electrically connected by the connectors 5351, 5352, and 5353. An element such as a socket, or the like, capable of connecting the connectors 5351, 5352, and 5353 to the first PCB 5310 and the second PCB 5320 is provided, and when both ends of the connectors 5351, 5352, and 5353 are connected to the element, the first PCB 5310 and the second PCB 5320 may be electrically connected.

The connectors 5351, 5352, and 5353 may be provided in plurality. In FIG. 30, three connectors 5351, 5352, and 5353 are connected to the first PCB 5310 and the second PCB 5320. The number and positions of the connectors 5351, 5352, and 5353 may be varied according to a design of the solar cell module 5300.

The connectors 5351, 5352, and 5353 may be configured to support the second surface 5312 of the first PCB 5310. As illustrated in FIG. 30, when the connectors 5351, 5352, and 5353 are disposed between the first PCB 5310 and the second PCB 5320, the second surface 5312 of the first PCB 5310 may be supported.

A battery 5370 may be mounted on the second surface 5312 of the first PCB 5310, and thus, both surfaces 5311 and 5312 of the first PCB 5310 may be utilized for mounting a component, and similarly, both surfaces 5321 and 5322 of the second PCB 5320 may also be utilized for mounting a component. In FIG. 30, a configuration in which an electric element 5345 is mounted on the second surface 5322 of the second PCB 5320 is illustrated.

The second PCB 5320 may be fixated to the cases 5191 and 5192 (please refer to FIG. 24) through screw fastening. A hole 5324 is formed on the second PCB 5320, and a screw fastening member corresponding to the hole may be formed in the cases 5191 and 5192. In a state in which the second surface 5322 of the second PCB 5320 is disposed to face an inner bottom surface of the cases 5191 and 5192, when a screw is fastened to the screw fastening member through the hole 5324, the second PCB 5230 is fixated. The number and positions of the hole 5324 and the screw fastening member may be varied according to a design.

In a state in which the second PCB 5320 is fixated to the cases 5191 and 5192, when the connectors 5351, 5352, and 5353 are connected to the second PCB 5320 and the first PCB 5310 is installed on the connectors 5351, 5352, and 5353, component mounting of the solar cell module 5300 within the cases 5191 and 5192 is completed.

In this manner, when the both surfaces 5311 and 5312 of the first PCB 5310 and both surfaces 5321 and 5322 of the second PCB 5320 are utilized for mounting components of the solar cell module 5300, a size of the solar cell module 5300 may be further reduced.

### [Industrial Applicability]

The present invention can be applied to an industrial field related to a solar cell module.

## Claims

1. A solar cell module (1000) comprising:
a printed circuit board (1010) having an electrode connection part (1060);
at least one solar cell (1021, 1022, 1023, 1024) mounted on the PCB (1010) and electrically connected to the electrode connection part (1060); and
an encapsulant layer (1030) covering the at least one solar cell and formed of a material including silicone,
wherein the encapsulant layer (1030) has light transmittance of 80% or greater with respect to light having a wavelength of 300 nm, light transmittance of 91% to 93% with respect to light having a wavelength of 350 nm, and light transmittance of 93% to 94% with respect to light having a wavelength of 400 nm to 700 nm,
wherein the encapsulant layer (1030) has a thickness ranging from 200*µ*m to 1,000*µ*m,
wherein the printed circuit board (1010) has a first surface and a second surface facing in mutually opposite directions, the electrode connection part (1060) is provided on the first surface, and a circuit wiring (1011) electrically connected to the electrode connection part (1060) is provided on the second surface,
the at least one solar cell (1021, 1022, 1023, 1024) is mounted on the first surface,
the solar cell module further comprises an electronic component mounted on the printed circuit board and electrically connected to the circuit wiring (1011), and
the electronic component includes any one of an electric element configured to be driven by electric power produced by the solar cell and a circuit component (1300) configured to control electric power produced by the solar cell, and is mounted on the second surface,
wherein the electric element includes:
a communication unit configured to transmit and receive a signal to and from an external device; and
a sensor part (1400) configured to sense a change in a measurement target such that the solar cell module operates as a sensor.

2. The solar cell module of claim 1, further comprising:
a dam layer (1040) coupled to one surface of the printed circuit board (1010) and formed on edges of the encapsulant layer (1030); and
a primer layer provided between the at least one solar cell (1021, 1022, 1023, 1024) and the encapsulant layer (1030) and bonding the encapsulant layer (1030) to the at least one solar cell (1021, 1022, 1023, 1024).

3. The solar cell module of claim 1, further comprising:
a case (2800) formed to accommodate the PCB (2010);
a window (2900) formed of a transparent material, covering the at least one solar cell accommodated in the case (2800), and coupled to the case; and
a battery (2500) installed on the second surface, electrically connected to the circuit wiring (2011), and storing electric power produced by the at least one solar cell (2021, 2022, 2023, 2024).

4. The solar cell module of claim 3, wherein
a coupling part configured to fixate the PCB (2010) to the inside of the case (2800) is provided in the case (2800), and
the coupling part (2810, 2820) separates the PCB (2010) from a bottom surface of the case (2800) so as to be farther than a height of the electronic component such that the electronic component mounted on the second surface of the PCB (2010) is not in contact with the bottom surface of the case (2800).

5. A method for manufacturing a solar cell module according to claim 1, the method comprising:
preparing a printed circuit board (1010) having an electrode connection part (1060) on a first surface thereof and having a circuit wiring (1011) on a second surface thereof facing a direction opposite to a direction of the first surface; and
performing a first process of forming at least one solar cell (1021, 1022, 1023, 1024) and an encapsulant layer (1030) on the first surface of the printed circuit bard (1010) and a second process of mounting a circuit component (1300) or an electric element on the second surface of the printed circuit board (1010) regardless of order,
wherein,
the first process includes:
mounting the at least one solar cell (1021, 1022, 1023, 1024) on one surface of the printed circuit board (1010) so as to electrically connect the at least one solar cell (1021, 1022, 1023, 1024) to the electrode connection part (1060);
dispensing a liquid encapsulant layer material formed of a material including silicone to cover the at least one solar cell (1021, 1022, 1023, 1024); thermally curing the encapsulant layer material to form an encapsulant layer (1030); and
cutting a solar cell module assembly formed by the preparing operation and the thermally curing operation into a unit size of a solar cell module, and
the second process includes mounting the circuit component (1300) or the electric element on the second surface using a surface mount technology of mounting a component by applying heat in a furnace.

6. The method of claim 5, wherein the liquid encapsulant layer material has viscosity of 40 Pa·s or greater.

7. The method of claim 5, wherein the first process further comprises:
forming a dam layer (1040) on the first surface of the printed circuit board (1010) between the preparing operation and the dispensing operation,
wherein the mounting of at least one solar cell (1021, 1022, 1023, 1024) and the forming of a dam layer (1040) are performed regardless of order,
wherein the liquid encapsulant layer material has viscosity of 10 Pa·s or less.

8. The method of claim 5, wherein the first process further comprises:
disposing a primer material on the at least one solar cell and curing the primer material at 90°C to 110°C for 20 to 40 minutes to form a primer layer, after the mounting of the solar cell,
wherein, in the thermally curing of the encapsulant layer material, the encapsulant layer material is heat-treated at 130°C to 170°C for 30 to 150 minutes.

9. The method of claim 5, wherein the first process includes:
attaching a unit grid to the first surface of the PCB to form a dam layer;
mounting at least one solar cell on every exposed region of the PCB exposed through the unit grid;
dispensing a liquid encapsulant layer material formed of a material including silicone to every exposed region of the PCB to cover the at least one solar cell; and
thermally curing the encapsulant layer material to form an encapsulant layer.

## Patentansprüche

1. Solarzellenmodul (1000) umfassend:
eine Leiterplatte (1010) mit einem Elektrodenverbindungsteil (1060);
zumindest eine Solarzelle (1021, 1022, 1023, 1024), die auf der PCB (1010) montiert und elektrisch mit dem Elektrodenverbindungsteil (1060) verbunden ist; und
eine Verkapselungsschicht (1030), die die zumindest eine Solarzelle bedeckt und aus einem Material gebildet ist, das Silikon enthält,
wobei die Verkapselungsschicht (1030) eine Lichtdurchlässigkeit von 80 % oder mehr in Bezug auf Licht mit einer Wellenlänge von 300 nm, eine Lichtdurchlässigkeit von 91 % bis 93 % in Bezug auf Licht mit einer Wellenlänge von 350 nm und eine Lichtdurchlässigkeit von 93 % bis 94 % in Bezug auf Licht mit einer Wellenlänge von 400 nm bis 700 nm aufweist,
wobei die Verkapselungsschicht (1030) eine Dicke im Bereich von 200 µm bis 1000 µm hat,
wobei die Leiterplatte (1010) eine erste Oberfläche und eine zweite Oberfläche aufweist, die in einander entgegengesetzten Richtungen zeigen, das Elektrodenverbindungsteil (1060) auf der ersten Oberfläche bereitgestellt ist und eine Schaltungsverdrahtung (1011), die elektrisch mit dem Elektrodenverbindungsteil (1060) verbunden ist, auf der zweiten Oberfläche bereitgestellt ist,
die zumindest eine Solarzelle (1021, 1022, 1023, 1024) auf der ersten Oberfläche montiert ist,
das Solarzellenmodul ferner ein elektronisches Bauteil umfasst, das auf der Leiterplatte montiert und elektrisch mit der Schaltungsverdrahtung (1011) verbunden ist, und
das elektronische Bauteil eines von einem elektrischen Element, das eingerichtet ist, um durch einen von der Solarzelle erzeugten elektrischen Strom betrieben zu werden, und einem Schaltungsbauteil (1300) umfasst, das eingerichtet ist, um einen von der Solarzelle erzeugten elektrischen Strom zu steuern, und auf der zweiten Oberfläche montiert ist,
wobei das elektrische Element umfasst:
eine Kommunikationseinheit, die zum Senden und Empfangen eines Signals zu und von einem externen Gerät eingerichtet ist; und
ein Sensorteil (1400), das zum Erfassen einer Änderung in einem Messziel eingerichtet ist, so dass das Solarzellenmodul als ein Sensor arbeitet.

2. Solarzellenmodul nach Anspruch 1, ferner umfassend:
eine Sperrschicht (1040), die mit einer Oberfläche der Leiterplatte (1010) gekoppelt ist und an Rändern der Verkapselungsschicht (1030) ausgebildet ist; und
eine Primerschicht, die zwischen der zumindest einen Solarzelle (1021, 1022, 1023, 1024) und der Verkapselungsschicht (1030) bereitgestellt ist und die Verkapselungsschicht (1030) mit der zumindest einen Solarzelle (1021, 1022, 1023, 1024) verbindet.

3. Solarzellenmodul nach Anspruch 1, ferner umfassend:
ein Gehäuse (2800), das ausgebildet ist, um die PCB (2010) aufzunehmen;
ein aus einem transparenten Material ausgebildetes Fenster (2900), das zumindest eine Solarzelle bedeckt, die in dem Gehäuse (2800) aufgenommen ist, und mit dem Gehäuse gekoppelt ist; und
eine Batterie (2500), die auf der zweiten Oberfläche installiert ist, elektrisch mit der Schaltungsverdrahtung (2011) verbunden ist und elektrische Energie speichert, die von der zumindest einen Solarzelle (2021, 2022, 2023, 2024) erzeugt wird.

4. Solarzellenmodul nach Anspruch 3, wobei ein Kopplungsteil in dem Gehäuse (2800) bereitgestellt ist, das eingerichtet ist, um die PCB (2010) an der Innenseite des Gehäuses (2800) zu befestigen, und
das Kopplungsteil (2810, 2820) die PCB (2010) von einer Unterseite des Gehäuses (2800) trennt, um weiter als eine Höhe des elektronischen Bauteils entfernt zu sein, so dass das elektronische Bauteil, das auf der zweiten Oberfläche der PCB (2010) montiert ist, nicht mit der Unterseite des Gehäuses (2800) in Kontakt steht.

5. Verfahren zur Herstellung eines Solarzellenmoduls nach Anspruch 1, wobei das Verfahren umfasst:
Vorbereiten einer Leiterplatte (1010) mit einem Elektrodenverbindungsteil (1060) auf ihrer ersten Oberfläche und mit einer Schaltungsverdrahtung (1011) auf ihrer zweiten Oberfläche, die in eine Richtung entgegengesetzt zu einer Richtung der ersten Oberfläche zeigt; und
Durchführen eines ersten Prozesses zum Ausbilden zumindest einer Solarzelle (1021, 1022, 1023, 1024) und einer Verkapselungsschicht (1030) auf der ersten Oberfläche der Leiterplatte (1010) und eines zweiten Prozesses zum Montieren einer Schaltungsverdrahtung (1300) oder eines elektrischen Elements auf der zweiten Oberfläche der Leiterplatte (1010) ungeachtet einer Reihenfolge,
wobei der erste Prozess umfasst:
Montieren der zumindest einen Solarzelle (1021, 1022, 1023, 1024) auf einer Oberfläche der Leiterplatte (1010), um die zumindest eine Solarzelle (1021, 1022, 1023, 1024) elektrisch mit dem Elektrodenverbindungsteil (1060) zu verbinden;
Ausgeben eines flüssigen Verkapselungsschichtmaterials, das aus einem Material gebildet ist, das Silikon enthält, um die zumindest eine Solarzelle (1021, 1022, 1023, 1024) zu bedecken;
thermisches Aushärten des Verkapselungsschichtmaterials, um eine Verkapselungsschicht (1030) zu bilden; und
Schneiden einer durch den Vorbereitungsvorgang und den thermischen Aushärtungsvorgang gebildeten Solarzellenmodulanordnung in eine Einheitsgröße eines Solarzellenmoduls, und
der zweite Prozess ein Montieren des Schaltungsbauteils (1300) oder des elektrischen Elements auf der zweiten Oberfläche unter Verwendung einer Oberflächenmontagetechnologie zum Montieren eines Bauteils durch Anwenden von Wärme in einem Ofen umfasst.

6. Verfahren nach Anspruch 5, wobei das flüssige Verkapselungsschichtmaterial eine Viskosität von 40 Pa·s oder mehr aufweist.

7. Verfahren nach Anspruch 5, wobei der erste Prozess ferner umfasst:
Bilden einer Dammschicht (1040) auf der ersten Oberfläche der Leiterplatte (1010) zwischen dem Vorbereitungsvorgang und dem Ausgabevorgang,
wobei das Montieren zumindest einer Solarzelle (1021, 1022, 1023, 1024) und das Bilden einer Dammschicht (1040) ungeachtet einer Reihenfolge durchgeführt werden, wobei das flüssige Verkapselungsschichtmaterial eine Viskosität von 10 Pa·s oder weniger aufweist.

8. Verfahren nach Anspruch 5, wobei der erste Prozess ferner umfasst:
Anordnen eines Primermaterials auf der zumindest einen Solarzelle und Aushärten des Primermaterials bei 90 °C bis 110 °C für 20 bis 40 Minuten zum Bilden einer Primerschicht nach dem Montieren der Solarzelle,
wobei beim thermischen Aushärten des Verkapselungsschichtmaterials das Verkapselungsschichtmaterial bei 130 °C bis 170 °C für 30 bis 150 Minuten wärmebehandelt wird.

9. Verfahren nach Anspruch 5, wobei der erste Prozess umfasst:
Anbringen eines Einheitsgitters an der ersten Oberfläche der PCB, um eine Dammschicht zu bilden;
Montieren zumindest einer Solarzelle an jedem freigelegten Bereich der PCB, der durch das Einheitsgitter freigelegt ist;
Ausgeben eines flüssigen Verkapselungsschichtmaterials, das aus einem Material gebildet ist, das Silikon enthält, auf jeden freigelegten Bereich der PCB, um die zumindest eine Solarzelle zu bedecken; und
thermisches Aushärten des Verkapselungsschichtmaterials, um eine Verkapselungsschicht zu bilden.

## Revendications

1. Cellule solaire (1000) comprenant :
une carte de circuit imprimé (1010) ayant une partie de connexion d'électrode (1060) ;
au moins une cellule solaire (1021, 1022, 1023, 1024) montée sur la carte de circuit imprimé (1010) et connectée électriquement à la partie de connexion d'électrode (1060); et
une couche d'encapsulation (1030) recouvrant ladite cellule solaire et constituée d'un matériau contenant de la silicone,
dans laquelle la couche d'encapsulation (1030) a une transmittance lumineuse de 80 % ou plus par rapport à la lumière ayant une longueur d'onde de 300 nm, une transmittance lumineuse comprise entre 91 % et 93 % par rapport à la lumière ayant une longueur d'onde de 350 nm, et une transmittance lumineuse comprise entre 93 % et 94 % par rapport à la lumière ayant une longueur d'onde comprise entre 400 nm et 700 nm,
dans laquelle la couche d'encapsulation (1030) ayant une épaisseur comprise entre 200 *µ*m et 1 000 *µ*m*,*
dans laquelle la carte de circuit imprimée (1010) a une première surface et une seconde surface se faisant face dans des directions opposées, la partie de connexion d'électrode (1060) est disposée sur la première surface, et un câblage de circuit (1011) connectée électriquement à la seconde partie de connexion d'électrode (1060) est disposée sur la seconde surface,
ladite cellule solaire (1021, 1022, 1023, 1024) est montée sur la première surface,
le module de cellules solaires comprend en outre un composant électronique monté sur la carte de circuit imprimé et connecté électriquement au câblage de circuit (1011), et
le composant électronique comprend l'un élément parmi un élément électrique conçu pour être excité par la puissance électrique produite par la cellule solaire et un composant de circuit (1300) conçu pour régler la puissance électrique produite par la cellule solaire, et est monté sur la seconde surface,
dans laquelle l'élément électrique comprend :
une unité de communication conçue pour émettre un signal à un dispositif externe et le recevoir en provenance de ce dernier ; et
une partie de capteur (1400) conçue pour détecter un changement dans une cible de mesure de sorte que le module de cellules solaires fait office de capteur.

2. Module de cellules solaires selon la revendication 1, comprenant en outre :
une couche barrière (1040) couplée à une surface de la carte de circuit imprimé et formée sur des bords de la couche d'encapsulation (1030) ; et
une couche d'amorce disposée entre ladite cellule solaire (1021, 1022, 1023, 1024) et la couche d'encapsulation (1030) et collant la couche d'encapsulation (230) à ladite cellule solaire (1021, 1022, 1023, 1024).

3. Module de cellules solaires selon la revendication 1, comprenant en outre :
un boîtier (2800) conçu pour loger la carte de circuit imprimé (2010) ;
une fenêtre (2900) constituée d'un matériau transparent, recouvrant ladite cellule solaire logée dans le boîtier (2800), et couplée au boîtier ; et
une batterie (2500) installée sur la seconde surface, connectée électriquement au câble au câblage de circuit (2011), et stockant la puissance électrique produite par au moins une cellule solaire (2021, 2022, 2023, 2024).

4. Module de cellules solaires selon la revendication 3, dans lequel
une partie d'accouplement conçue pour fixer la carte de circuit imprimé (2010) à l'intérieur du logement (2800) est disposée dans le boîtier (2800), et
la partie d'accouplement (2810, 2820) sépare la carte de circuit imprimé (2010) d'une surface de fond du boîtier (2800) de façon à être plus haute qu'une hauteur du composant électronique de sorte que le composant électronique monté sur la seconde surface de la carte de circuit imprimé (2010) ne soit pas en contact avec la surface de fond du boîtier (2800).

5. Procédé de fabrication de module de cellules solaires selon la revendication 1, le procédé consistant à:
préparer une carte de circuit imprimé (1010) ayant une partie de connexion d'électrode (1060) sur sa première surface et ayant un câblage de circuit (1011) sur sa seconde surface faisant face à une direction opposée à une direction de la première surface ; et
effectuer un premier processus de formation d'au moins une cellule solaire (1021, 1022, 1023, 1024) et d'une couche d'encapsulation (1030) sur la première surface de la carte de circuit imprimé (1010) et un second processus de montage d'un composant de circuit (1300) ou d'un élément électrique sur la seconde surface de la carte de circuit imprimé (1010) indépendamment de l'ordre,
dans lequel,
le premier processus consiste à :
monter ladite cellule solaire (1021, 1022, 1023, 1024) sur une surface de la carte de circuit imprimé (1010) de manière à connecter électriquement ladite cellule solaire à la partie de connexion d'électrode (1060) ;
distribuer un matériau liquide de couche d'encapsulation constitué d'un matériau contenant de la silicone pour recouvrir ladite cellule solaire (1021, 1022, 1023, 1024) ;
durcir thermiquement le matériau de la couche d'encapsulation pour former une couche d'encapsulation (1030) ; et
couper un ensemble module de cellules solaires formé par l'opération de préparation et l'opération de durcissement thermique dans une taille unitaire d'un module de cellules solaires, et
le second processus consiste à monter le composant de circuit (1300) ou l'élément électrique sur la seconde surface à l'aide d'une technologie de montage en surface de montage d'un composant par application de chaleur dans un four.

6. Procédé selon la revendication 5, dans lequel le matériau liquide de la couche d'encapsulation a une viscosité de 40 Pa·s ou plus.

7. Procédé selon la revendication 5, dans lequel le premier processus consiste en outre à :
former une couche barrière s(1040) sur la première surface de la carte de circuit imprimé (1010) entre l'opération de préparation et l'opération de distribution,
dans lequel le montage d'au moins une cellule solaire (1021, 1022, 1023, 1024) et la formation d'une couche barrière (1040) sont effectués indépendamment de l'ordre,
dans lequel le matériau liquide de la couche d'encapsulation a une viscosité de 10 Pa·s ou moins.

8. Procédé selon la revendication 5, dans lequel le premier processus consiste en outre à :
déposer un matériau d'amorce sur ladite cellule solaire et durcir le matériau d'amorce entre 90°C et 110°C pendant 20 à 40 minutes pour former une couche d'amorce, après le montage de la cellule solaire,
dans lequel, pendant le durcissement thermique du matériau de couche d'encapsulation, le matériau de couche d'encapsulation est traité à une chaleur entre 130°C et 170°C pendant 30 à 150 minutes.

9. Procédé selon la revendication 5, dans lequel le premier processus consiste à :
fixer une grille d'unité à la première surface de la carte de circuit imprimé pour former une couche barrière ;
monter au moins une cellule solaire sur chaque région apparente de la carte de circuit imprimé apparente à travers la grille d'unité ;
distribuer un matériau liquide de couche d'encapsulation constitué d'un matériau contenant de la silicone dans chaque région apparente de la carte de circuit imprimé pour recouvrir ladite cellule solaire; et
durcir thermiquement le matériau de la couche d'encapsulation pour former une couche d'encapsulation.
